# EUROPÄISCHE PATENTSCHRIFT

(11) **EP 2 989 872 B1**
(45) Veröffentlichungstag und Bekanntmachung des Hinweises auf die Patenterteilung: **12.08.2020**
(21) Anmeldenummer: 14724333.1
(22) Anmeldetag: 24.04.2014
(51) Int. Cl.: H05K 13/08

(54) **PLATZIERVORRICHTUNG UND PLATZIERVERFAHREN**
PLACEMENT APPARATUS AND PLACEMENT METHOD
DISPOSITIF ET PROCÉDÉ DE PLACEMENT

(30) Priorität: 25.04.2013 DE 102013207598
(43) Veröffentlichungstag der Anmeldung: 02.03.2016
(73) Patentinhaber: Finetech GmbH & Co. KG, 12681 Berlin (DE)
(72) Erfinder: WINKLER, Matthias, 01728 Bannewitz (DE); KOCH, Michael, 16348 Wandlitz (DE)
(74) Vertreter: Maikowski & Ninnemann Patentanwälte Partnerschaft mbB
(86) Internationale Anmeldenummer: PCT/EP2014/058352
(87) Internationale Veröffentlichungsnummer: WO 2014/174017

(56) Entgegenhaltungen:
- EP-A2- 0 968 637
- EP-A2- 1 065 917
- EP-A2- 1 110 439
- WO-A2-01/67491
- DE-A1- 19 749 953
- DE-A1- 19 857 263
- US-A1- 2002 034 324
- US-A1- 2007 013 803
- US-B1- 6 246 789

## Beschreibung

Die Erfindung betrifft eine Platziervorrichtung zum lagegenauen Bestücken eines ersten Platzierpartners mit einem zweiten Platzierpartner gemäß Anspruch 1 und ein Platzierverfahren zum lagegenauen Bestücken eines ersten Platzierpartners mit einem zweiten Platzierpartner gemäß Anspruch 8.

Bei der Herstellung insbesondere von elektronischen, optischen und optoelektronischen Erzeugnissen sowie von Mikrosystemen besteht die Aufgabe, Bauelemente automatisch auf einem Substrat anzuordnen. Die Bauelemente können z.B. Speicherbausteine oder Mikroprozessoren sein, die auf einem Substrat abgesetzt werden müssen. Andere Beispiele sind die Montage von VCSEL-Bauelementen, Photodioden, MEMS-Bauelementen oder Chip-on-Glass-Bauelementen.

Anschließend erfolgt eine Weiterverarbeitung des Substrates zusammen mit dem Bauelement. Insbesondere erfolgt u.U. eine dauerhaftere Verbindung von Substrat und Bauelement, z.B. durch Thermokompression, Ultraschallverfahren, Löten oder Kleben.

Bekannt sind Platziervorrichtungen z.B. aus der DD 242 320 A1 oder der DE 195 24 475 C1, bei denen das Ablegen eines Bauelementes auf einem Substrat mithilfe von Hebelarmen erfolgt.

Die DE 197 49 953 A1 beschreibt ein Verfahren und eine Vorrichtung zum lagegenauen Platzieren von Baugruppen auf Kontaktflächen von Leiterplatten mit dem eine optische Überlagerung der Bilder der Unterseite der zu platzierenden Baugruppe und der Verbindungsfläche auf einer Leiterplatte unter Verwendung von Kameras und eines Bildschirms erfolgt. Durch mindestens zwei Kamerasysteme mit jeweils mindestens zwei Kameras wird aus einem definierten gleichen Abstand gleichzeitig die Unterseite des zu platzierenden Bauelements und die Kontaktfläche auf der Leiterplatte abgebildet und beide Abbildungen werden auf einem Bildschirm zeitgleich überlagert dargestellt, wobei die Positionierung der Leiterplatte in y-Richtung und die Positionierung des Bauelements in x- und Phi-Richtung bis zur exakten Deckungsgleichheit vorgenommen werden und wobei das Bauelement vor dem Aufsetzen auf die Leiterplatte um einen vorgegebenen Abstand verfahren wird.

Aus der DE 198 57 263 A1 ist ein Verfahren zum Positionieren von Bauelementen auf Trägern bekannt, bei dem mindestens ein Bauelement von einem Bauelementehalter gehalten wird, mindestens ein Träger von einem Trägerhalter gehalten wird und nach der relativen Ausrichtung von Bauelement und Träger die Komponenten mit jeweiligen Kontaktflächen aufeinander zugeführt werden. Das Bauelement und der Träger werden in der Weise gehalten, dass sich ihre Kontaktflächen mit Abstand in z-Richtung gegenüberliegen, wobei zwischen den Kontaktflächen mindestens eine erste Bildaufnahmeeinrichtung positioniert ist, welche ein Bild einer Kontaktfläche des Bauelementes oder des Trägers aufnimmt, eine Bilderzeugungseinrichtung vorgesehen ist, welche ein weiteres Bild erzeugt. Die Bilder werden mittels einer elektronischen Schaltung synchron, übereinander-liegend auf einem Bildschirm dargestellt und die relative Ausrichtung von Bauelement und Träger wird durch Bewegen des Bauelementehalters und/oder des Trägerhalters bewirkt, wobei die Bilder auf dem Bildschirm verschoben werden und die Lage der Bilder auf dem Bildschirm als Ausrichtungs-kriterium verwendet wird.

Die WO 01/67491 A2 beschreibt ein Verfahren und eine Vorrichtung zum Justieren eines Bauelementes auf einem Substrat unter Verwendung von digitaler Merkmaltrennung.

Weitere Platzierungsvorrichtungen bzw. -verfahren sind in den Dokumenten EP 1 065 917 A2, EP 0 968 439 A2, EP 1 110 439 A2, US 6 246 789 B1, US 2002/034324 A1 und US 2007/013803 A1 beschrieben.

Um immer höhere Platziergenauigkeiten realisieren zu können, werden Platziervorrichtungen und -verfahren benötigt, die einfach und effizient herstellbar sowie einsetzbar sind.

Diese Aufgabe wird durch eine Platziervorrichtung mit den Merkmalen des Anspruchs 1 gelöst.

Dabei dient mindestens eine Kameravorrichtung zur Aufnahme separater Bilder des ersten Platzierpartners oder einer Haltevorrichtung des ersten Platzierpartners und des mindestens einen zweiten Platzierpartners oder einer Haltevorrichtung für den mindestens einen zweiten Platzierpartner. Es werden also Bilder der Platzierpartner oder der jeweiligen Haltevorrichtungen aufgenommen. Ferner dient eine Lageauswertungsvorrichtung zur Erstellung eines Ausgabedatensatzes aus einer Verarbeitung der zuvor gewonnenen Bilder, wobei der Ausgabedatensatz aus einer Verarbeitung der zuvor gewonnenen Bilder eine Überlagerung der Bilder zur Anzeige auf einer Ausgabevorrichtung aufweist und das zu erwartende Platzierergebnis der Vorrichtung visualisiert, nämlich umfassend ein Bild, welches aus mehreren überlagerten Kamerabildern besteht, basierend auf dem Zustand der Platziervorrichtung zum jeweiligen Zeitpunkt der Bildaufnahme der Bilder.

Dabei dient die Platziervorrichtung dem lagegenauen Ausrichten und / oder Bestücken eines ersten Platzierpartners mit mindestens einem dazu komplementären zweiten Platzierpartner. Komplementär bedeutet, dass im Zusammenbau die beiden Platzierpartner zusammen passen.

Vorteilhafterweise weist der erste Platzierpartner ein Substrat und der mindestens zweite Platzierpartner mindestens ein Bauelement auf. Je nach Montagesituation kann ein Bauelement auf einem Substrat platziert werden und umgekehrt. Auch ist es möglich, dass nicht nur die Substrate und Bauelemente platziert werden, sondern auch noch zusätzliche Teile an den beiden Platzierpartnern angeordnet sein können. In jedem Fall sind die Platzierpartner komplementär zueinander.

In einer vorteilhaften Ausführungsform ist eine erste Kameravorrichtung als eine Substratkameravorrichtung zur Aufnahme von Bildern des Substrates und eine zweite Kameravorrichtung als eine Bauelementkameravorrichtung zur Aufnahme von Bildern der Unterseite des Bauelementes ausgebildet.

Durch eine Justiervorrichtung zur relativen Ausrichtung der Platzierpartner (z.B. Substrat und Bauelement) können diese zueinander in mindestens einer Raumrichtung und / oder Drehrichtung bewegt werden, um ein genaues Platzierergebnis zu erreichen. Diese Bewegungen können vorzugsweise durch motorische Achsen oder andere Mechanismen ausgeführt werden, wobei im Folgenden hierfür der Begriff Achse Verwendung findet.

Die Platziervorrichtung weist eine Reihe von Korrekturmitteln auf. Durch ein erstes Korrekturmittel werden optische Fehler, insbesondere Verzeichnungen, in den Bildern der Kameravorrichtungen mittels Kalibrierdaten minimiert. Ein zweites Korrekturmittel dient der Verrechnung von mechanischen Fehlern der Platziervorrichtung mit Kalibrierdaten.

Die Korrekturmittel können einzeln oder in beliebigen Kombinationen untereinander verwendet werden.

Die Lageauswertungsvorrichtung dient der Erstellung eines Ausgabedatensatzes aus einer Verarbeitung der zuvor gewonnenen Bilder, wobei der Ausgabedatensatz eine Überlagerung der Bilder zur Anzeige auf einer Ausgabevorrichtung aufweist. Der Ausgabedatensatz visualisiert hier das zu erwartende Platzierergebnis der Vorrichtung, insbesondere die Platzierposition und Drehung. Dies erlaubt es z.B. einem Anlagenbediener, schnell zu erkennen, ob die Platzierung der Platzierpartner (z.B. Bauelement und Substrat) richtig erfolgen würde.

Eine weitere Ausführungsform der Platziervorrichtung weist ein Mittel zur Erzeugung grafischer Objekte und deren Darstellung im Ausgabedatensatz auf. Die Anzeige dieser Objekte ist eine weitere Möglichkeit der Bewertung des Ausgabedatensatzes, insbesondere an signifikanten Bildstellen, an welchen die Platzierpartner keine oder keine ausreichend erkennbaren Informationen zur Beurteilung des Platzierergebnisses durch den Anlagenbediener aufweisen.

Eine Vorrichtung zum Justieren und Ausrichten der Position der Platzierpartner basiert auf der Nutzung des Ausgabedatensatzes in einem geschlossenen Zyklus, wobei Änderungen der mechanischen Position der Platzierpartner (z.B. von Bauelement und / oder Substrat) zu veränderten Bildern der jeweiligen Kameravorrichtung führen und diese sich wiederum im Ausgabedatensatz wiederspiegeln. Der Zyklus endet mit der Entscheidung, beispielsweise durch den Anlagenbediener, dass das visuelle Abbild des Ausgabedatensatzes eine ausreichend genaue Positionierung der Platzierpartner darstellt. Nachfolgend kann die Platziervorrichtung mit der eingestellten Justierung eine exakte Bestückung vornehmen. Dabei wird ein Mittel zum Ausrichten und Justieren verwendet, das z.B. als Handsteuerung ausgebildet sein kann.

Eine weitere vorteilhafte Vorrichtung zum Justieren und Ausrichten der Position des zweiten Platzierelementes (z.B. eines Bauelementes) relativ zum ersten Platzierelement (z.B. einem Substrat) basiert auf der Nutzung des Ausgabedatensatzes in einem geschlossenen Zyklus, wobei die Justierung durch kontinuierliche Erzeugung des Ausgabedatensatzes nach Anpassung von Parametern der Platzierposition abläuft. Innerhalb des Zyklus erfolgen somit weder Änderungen der mechanischen Positionen der Platzierpartner noch werden neue Bilder von ihnen aufgenommen. Der Zyklus endet mit der Entscheidung, beispielsweise durch den Anlagenbediener, dass das visuelle Abbild des Ausgabedatensatzes eine ausreichend genaue Positionierung der Platzierpartner darstellt. Nachfolgend kann die Platziervorrichtung mit der eingestellten Justierung eine exakte Bestückung vornehmen.

Die Erzeugung und Darstellung des Ausgabedatensatzes in Echtzeit, so dass ein Bediener in die Lage versetzt wird, mit einer Justiervorrichtung eine räumliche Einstellung der mindestens zwei Platzierpartner zueinander in Abhängigkeit von dem visuellen Abbild des Ausgabedatensatzes verzögerungsfrei durchzuführen.

Eine weitere Ausführungsform weist eine Justiervorrichtung auf, mit der automatisch eine räumliche Einstellung der mindestens zwei Platzierpartner zueinander, beispielsweise durch ein Bilderkennungssystem erfolgt, wobei der Ausgabedatensatz das Ergebnis der automatischen Einstellung visualisiert, noch bevor die Platziervorrichtung diese Position eingenommen hat.

Die Platziervorrichtung weist darüber hinaus ein Mittel zum Absetzen des einen Platzierpartners auf den anderen auf, realisiert vorzugsweise durch motorische Achsen oder andere Mechanismen. Hierbei erfolgt die Verarbeitung der abschließend festgelegten Platzierposition unter Berücksichtigung des Ausgabedatensatzes und weiterer bekannter Parameter der Vorrichtung.

In einer weiteren Ausführungsform ist ein Mittel zur Weiterverarbeitung der Platzierpartner (z.B. Bauelement und Substrat), insbesondere ein Mittel zur Herstellung einer dauerhafteren Verbindung von Substrat und Bauelement durch Thermokompression, Ultraschallverfahren, Löten und / oder Kleben vorgesehen.

Die Aufgabe wird auch durch ein Platzierverfahren mit den Merkmalen des Anspruchs 8 gelöst.

Im Folgenden werden Ausführungsbeispiele der Erfindung anhand von Zeichnungen und Blockschaltbildern dargestellt. Dabei zeigt
Fig. 1 eine perspektivische Darstellung einer Ausführungsform einer Platziervorrichtung;
Fig. 2 eine perspektivische Darstellung einer weiteren Ausführungsform einer Platziervorrichtung;
Fig. 3 ein Blockschaltbild einer Ausführungsform einer Platziervorrichtung und eines damit auszuführenden Platzierverfahrens zur Erzeugung und Anzeige eines Ausgabedatensatzes in Form überlagerter Bildes von Substrat und Bauelement, ausgeführt mit Korrekturen optischer und mechanischer Fehler;
Fig. 4 ein Blockschaltbild einer Ausführungsform einer Platziervorrichtung und eines damit auszuführenden Platzierverfahrens zur Erzeugung und Anzeige eines Ausgabedatensatzes in Form überlagerter Bilder von Substrat und Bauelement, ausgeführt mit Korrekturen optischer und mechanischer Fehler, gekoppelt mit einem Bilderkennungssystem;
Fig. 5 eine Ausführungsform eines Platzierverfahrens mit einem Bauelement relativ zu einem Substrat;
Fig. 6 eine Ausführungsform eines Platzierverfahrens mit einem Bauelement relativ zu einem Substrat, wobei der Ausgabedatensatz an mehreren Kamerapositionen erstellt wird;
Fig. 7 eine Ausführungsform einer Lageauswertungsvorrichtung mit einem Mittel zur Erzeugung und Anzeige grafischer Objekte im Ausgabedatensatz;
Fig. 8 eine Ausführungsform eines Platzierverfahrens mit einem Bauelement relativ zu einem Substrat, wobei der Ausgabedatensatz an mehreren Kamerapositionen erstellt wird und zusätzlich synthetisch erzeugte grafische Objekte angewendet werden;
Fig. 9 ein Blockschaltbild einer Ausführungsform einer Platziervorrichtung und eines damit auszuführenden Platzierverfahrens zum Justieren und Ausrichten der Position des Bauelements relativ zum Substrat mittels Nachführung der beweglichen Achsen der Justiervorrichtung;
Fig. 10 ein Blockschaltbild einer Ausführungsform einer Platziervorrichtung und eines damit auszuführenden Platzierverfahrens zum Justieren und Ausrichten der Position des Bauelements relativ zum Substrat mittels Ausrichtung visueller Abbilder im Ausgabedatensatz.

In den folgenden Figuren werden Ausführungsformen beschrieben, bei der die Platzierpartner 1, 2 ein Substrat 1 und ein Bauelement 2 sind. Dabei wird davon ausgegangen, dass das Bauelement 2 auf das Substrat 1 aufgesetzt wird. Grundsätzlich ist es aber auch möglich, dass das Substrat 1 auf das Bauelement 2 aufgesetzt wird.

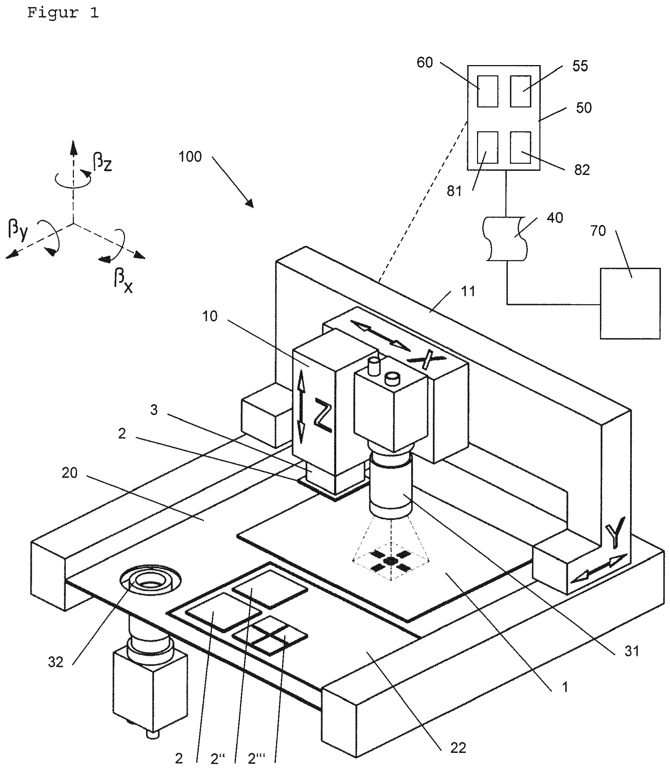

**In** **Fig. 1** ist eine Ausführungsform einer Platziervorrichtung 100 dargestellt. Solche Platziervorrichtungen 100 werden dazu verwendet, ein Bauelement 2 auf einem Substrat 1 anzuordnen. Das Bauelement 2 ist hier an einer Haltevorrichtung 3 unter einer Platziereinheit 10 an einem Portal 11 angeordnet, das Substrat 1 auf einer Unterlage 20. Die Unterlage 20 dient hier z.B. als Haltevorrichtung für das Substrat 1.

In der hier beschriebenen Ausführungsform ist eine Substratkameravorrichtung 31 beweglich, insbesondere an dem Portal 11, angeordnet.

Diese Darstellungsweise wird im Folgenden aus Gründen der Einfachheit beibehalten, wobei es grundsätzlich möglich ist, dass das Substrat 1 an der Platziereinheit 10 angeordnet wird und das Bauelement 2 auf der Unterlage 20 liegt.

In jedem Fall werden Bauelement 2 und Substrat 1 als Platzierpartner 1, 2 durch eine Bewegung zueinander geführt, wobei es grundsätzlich ohne Bedeutung ist, ob das Bauelement 2 und / oder das Substrat 1 bewegt werden.

Die Platziereinheit 10 am Portal 11 kann in Längs- und Querrichtung (X- und Y-Richtungen in Fig. 1) der Platziervorrichtung 100 verfahren werden. Zusätzlich kann die Platziereinheit 10 auch in vertikaler Richtung (Z-Richtung in Fig. 1) verfahren werden.

In einem Lagerbereich 22 liegen zum Platzieren vorbereitete Bauelemente 2', 2'', 2'''. Wenn die Platziereinheit 10 in diesen Lagerbereich 22 fährt, kann die Platziereinheit 10 in vertikaler Richtung nach unten verfahren werden, so dass eines der Bauelemente 2', 2", 2''' aufgenommen werden kann, um es später auf dem Substrat 1 zu platzieren. Grundsätzlich kann der Lagerbereich 22 auch an einer anderen Stelle, insbesondere auch außerhalb der Platziervorrichtung 100, angeordnet sein.

Für die erforderliche Präzision der Platzierung ist es erforderlich, dass der Aufbau und die Einrichtung der Platziervorrichtung 100 und die Ausrichtung des Bauelementes 1 zum Substrat 2 sehr genau erfolgen. Nur so ist bei einer Abfolge von Platziervorgängen eine hohe Wiederholgenauigkeit erreichbar.

Für die genaue, relative Ausrichtung der Platziereinheit 10 zum Substrat 1 werden Kameravorrichtungen 31, 32 eingesetzt.

An der Platziereinheit 10 ist als eine erste Kameravorrichtung eine Substratkameravorrichtung 31 angeordnet, deren Objektiv nach unten zeigt, so dass die unterhalb des Portals 11 liegende Unterlage 20 mit dem Substrat 1 erfasst werden kann. Die Substratkameravorrichtung 31 nimmt ein Bild des Substrates 1 auf, auf das das Bauelement 2 aufgesetzt werden soll. Dieses von oben aufgenommene Bild wird nachfolgend der Lageauswertungsvorrichtung 50 zugeführt.

Als zweite Kameravorrichtung 32 dient eine Bauelementkameravorrichtung 32, die in der dargestellten Ausführungsform stationär in der Basis der Platziervorrichtung 100 angeordnet, wobei das Objektiv nach oben zeigt.

Die Platziereinheit 10 nimmt - wie oben beschrieben - ein Bauelement 2 aus dem Lagerbereich 22 auf und fährt es über die Bauelementkameravorrichtung 32. Diese nimmt ein Bild des Bauelementes 2, z.B. eines Chips mit seinen Anschlüssen, auf und führt das Bild einer Lageauswertungsvorrichtung 50 zu.

Das beschriebene Verfahren und eine analoge Vorrichtung kann auch dazu genutzt werden, ein Bauelement 2', 2", 2''' vom Lagerbereich 20 aufzunehmen und in einem Zwischenschritt zu einem sich an der Platziereinheit 10 befindenden Werkzeug als Haltevorrichtung exakt auszurichten. Später kann in diesem Fall nicht das Bauelement 2', 2'', 2''' selbst, sondern das Werkzeug als Haltevorrichtung 3 zum Substrat 1 exakt ausgerichtet werden. Dieses Verfahren wird vorzugsweise dann angewandt, wenn das Bauelement die zur Ausrichtung relevanten Strukturen auf der Oberseite besitzt, wie bei Bauelement 2''' angedeutet.

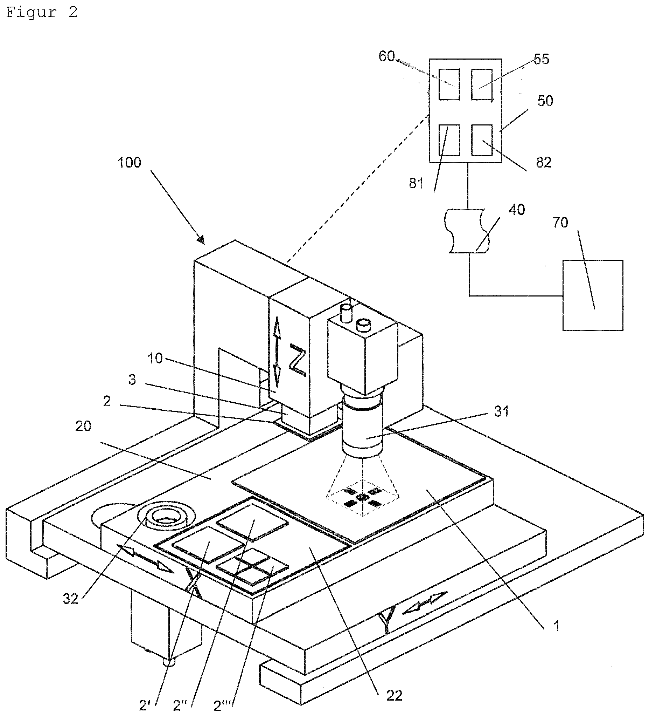

Fig. 2 zeigt eine weitere Ausführungsform einer Platziervorrichtung, bei der Substrat 2 in X- und Y-Richtung bewegt werden kann, das Bauelement 1 nur in Z-Richtung.

Neben den in Fig. 1 und Fig. 2 gezeigten Ausführungsformen sind beliebige Aufteilungen der Achsbewegungen X, Y und Z zu Substrat und Bauelement möglich, welche eine Ausrichtung und Platzierung von Bauelement zu Substrat gewährleisten, wobei die Kameravorrichtungen 31, 32 sowohl ortsfest als auch mitfahrend angeordnet sein können.

Auch können Drehungen βx, βy und βz (im Koordinatensystem der Fig. 1 angedeutet) vom Substrat und / oder Bauelement ausgeführt werden. Dabei ist zu beachten, dass die Drehungen grundsätzlich von einem oder mehreren Teilen der Platziervorrichtung durchgeführt werden können.

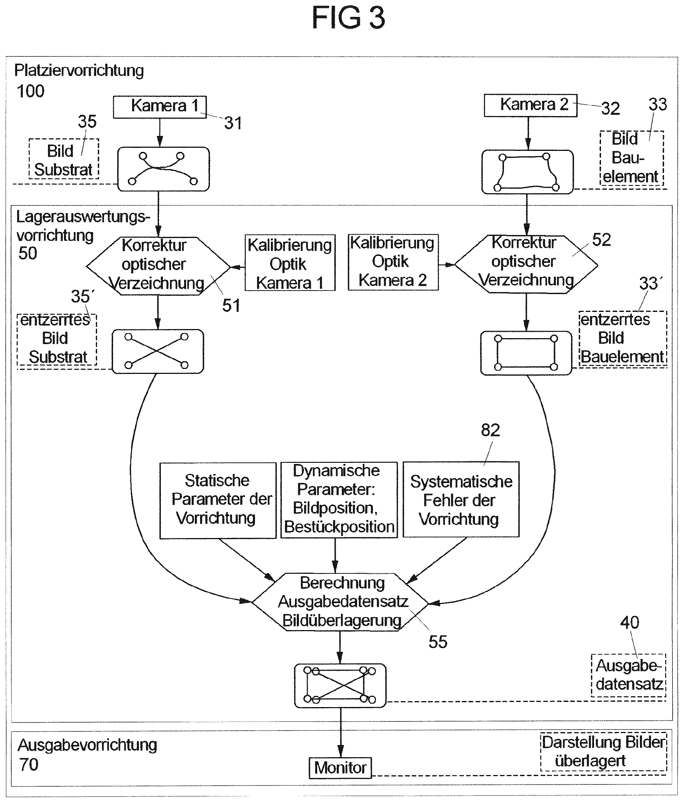

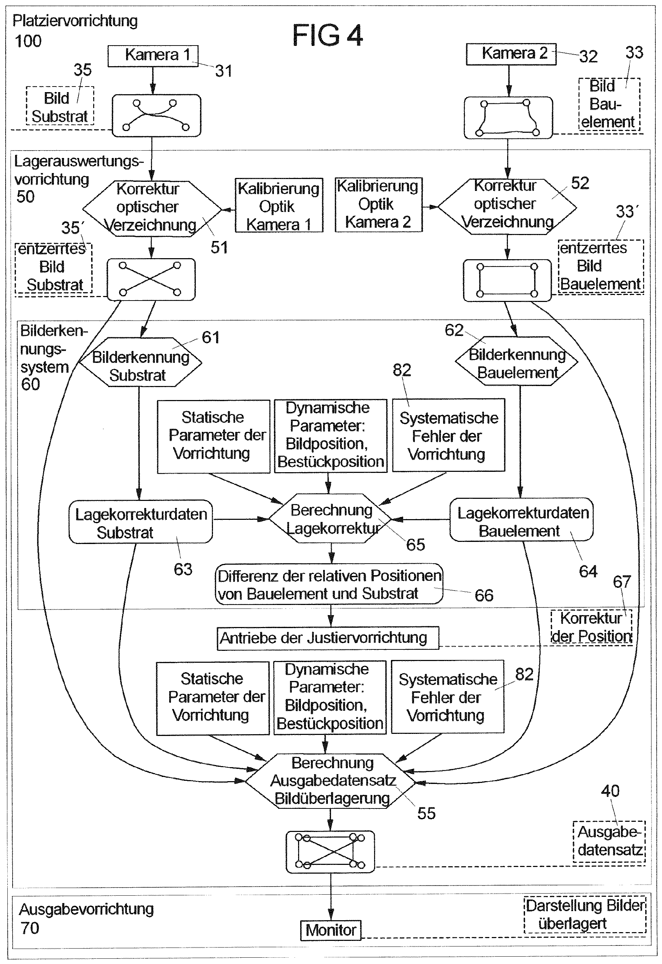

Fig. 3 zeigt ein Blockschaltbild einer Ausführungsform einer Platziervorrichtung und eines damit auszuführenden Platzierverfahrens zur Erzeugung und Anzeige eines Ausgabedatensatzes 40. In der Darstellung des Datenflusses zur Verarbeitung der Kamerabilder der Kameravorrichtungen 31, 32 sind diese in Fig. 3 und 4 jeweils verkürzt als "Kamera 1" und "Kamera 2" bezeichnet.

Es wird angenommen, dass in einer der oben beschriebenen Platziervorrichtung 100 die erste Kameravorrichtung 31 als Substratkameravorrichtung ein Bild eines Substrates 35 und die zweite Kameravorrichtung 32 als Bauelementkamera das Bild eines Bauelements 33 aufnimmt. Es sei bemerkt, dass es unerheblich ist, ob die Bilder der Platzierpartner von einer, zwei oder mehreren Kameravorrichtungen 31, 32 aufgenommen werden.

Die Bilder der Kameravorrichtungen 31, 32 werden zunächst durch Korrekturschritte 51, 52 bearbeitet, um die Wirkungen geometrischer Abbildungsfehler, insbesondere Verzeichnungen, zu minimieren. Durch Anwendung der Korrekturmittel 81 entstehen entzerrte Bilder 35', 33' von Substrat 1 und Bauelement 2.

Nachfolgend wird der Schritt der Erzeugung des Ausgabedatensatzes 40 durchgeführt. Ein computerimplementierter Algorithmus 55 berechnet für die zugeführten Bilder 35', 33' von Substrat 1 und Bauelement 2 unter Zuhilfenahme weiterer spezieller Parameter ein überlagertes Bild der Platzierpartner 1, 2. Die zugeführten Bilder unterliegen dabei geometrischer und bildtechnischer Veränderung, insbesondere Verschiebung, Drehung und Verzerrung sowie Änderungen von Farbe und Transparenz.

Der Anspruch des Algorithmus ist es, die zugeführten Bilder so zu überlagern, dass sich das visuelle Abbild des zu erwartenden Platzierergebnisses abbildet. Um dies zu realisieren, werden zur Ausführung der Operation spezielle Parameter zugeführt, die sich wie folgt klassifizieren:
Statische Parameter der Vorrichtung umfassen alle relevanten Einstellungen der angewendeten Ausführungsform einer Platziervorrichtung, welche unveränderlich und unabhängig vom Fügeprozess bekannt bzw. zuvor erfasst oder anderweitig kalibriert wurden. Diese Parameter sind insbesondere Nullpositionen von Achsen und räumliche Position feststehender Kameravorrichtungen relativ zueinander bzw. relativ zu einem festgelegten Nullpunkt. Weiterhin werden Parameter zum Pixelmaßstab der zugeführten Bilder 35', 33' angewendet.

Die dynamischen Parameter umfassen Einflussgrößen, die während der Durchführung des Prozesses zum Justieren und Ausrichten erfasst werden. Hierzu zählen insbesondere die räumliche Position beweglicher Kameravorrichtungen zum Zeitpunkt der jeweiligen Bilderfassung und relevante Achspositionen, beispielsweise die der Platziereinheit 10.

Systematische Fehler der Platziervorrichtung 100 können in einer weiteren vorteilhaften Ausführungsform dem Algorithmus zusätzlich zugeführt und verarbeitet werden (Korrekturmittel 82). Diese Parameter beinhalten bekannte Positionierfehler beim Vorgang des Absetzens eines Platzierpartners 1, 2, beispielsweise Linearitätsabweichungen in Achsen und Führungen aufgrund mechanischer Toleranzen und / oder durch Temperatureinflüsse. Die Verrechnung der systematischen Fehler zeigt im Ausgabedatensatz in der Regel nur eine geringfügige Wirkung, dennoch ist deren Nutzung im Algorithmus zur Realisierung des Anspruches entscheidend.

Alle genannten Parameter werden erfasst und dem Algorithmus in geeigneter Form zugeführt.

Das Ergebnis der Operation ist der Ausgabedatensatz 40, umfassend ein Bild, welches aus mehreren überlagerten Kamerabildern besteht, basierend auf dem Zustand der Platziervorrichtung zum jeweiligen Zeitpunkt der Bildaufnahme der Bilder 35', 33'. Dar Ausgabedatensatz 40 stellt somit eine visuelle Darstellung des zu erwartenden Platzierergebnisses der Platzierpartner unter den gegebenen Bedingungen dar. Bemerkenswert ist dabei, dass die Platziervorrichtung 100 noch nicht in der Absetzposition stehen muss, vielmehr können sich ein und / oder beide Platzierpartner 1, 2 noch über den Kameravorrichtungen 31, 32 befinden.

Die für die Erzeugung des Ausgabedatensatzes 40 genutzten Kamerabilder können jeweils auch an mehreren Positionen aufgenommen werden. Die Zuführung weiterer Kamerabilder vergrößert somit den Ausgabedatensatz 40, basierend auf den zu den Bildern zugeordneten Kamerapositionen. So kann sich beispielsweise im Ausgabedatensatz 40 die vollständige Kontaktfläche eines Bauelementes 2 aus der Zusammensetzung mehrerer Teilbilder von verschieden Aufnahmepositionen abbilden.

Der Ausgabedatensatz 40 wird in einer Ausgabevorrichtung 70, beispielsweise einem Monitor, in geeigneter Form angezeigt.

In einer vorteilhaften Ausführungsform können dem Anlagenbediener außerdem Werkzeuge zur Manipulation des Ausgabedatensatzes zur Verfügung stehen, welche zur Verbesserung der Erkennbarkeit der Platzierpartner 1, 2 dienen, beispielsweise zur Vergrößerung / Verkleinerung des Bildes sowie zur Änderung der Transparenz.

In einer weiteren Ausführungsform kann der Ausgabedatensatz 40 abgespeichert werden, um einen belegbaren Nachweis der Platzierposition der Platzierpartner 1, 2, beispielsweise zum Zwecke der Qualitätssicherung, zu generieren.

**Fig. 4** beschreibt eine weitere Ausführungsform gemäß Fig. 3, erweitert um eine automatische Bildverarbeitung.

Wie bei der Ausführungsform gemäß Fig. 3 werden auch hier ein entzerrtes Bild des Substrates 35' und ein entzerrtes Bild des Bauelementes 33' erzeugt.

Diese entzerrten Bilder 35', 33' werden dann an ein Bilderkennungssystem 60 übermittelt, das mit der Lageauswertungsvorrichtung 50 gekoppelt ist.

Dabei erfolgt für beide Bilder 35', 33' jeweils eine Bilderkennung 61, 62, bei der z.B. Marker ausgewertet werden, um die aktuelle Lage einer Platzierposition und eines Bauelements zu berechnen. Anschließend erfolgt die Berechnung der Lagekorrekturdaten 65 unter Verwendung der gewonnenen Lage der Platzierpartner und der programmierten Platzierposition. Zusätzlich kann eine vorteilhafte Ausführungsform die systematischen Fehler der Platziervorrichtung berücksichtigen (Korrekturmittel 82). Das Ergebnis dieser Operation (66) ist die Differenz der relativen Position des Bauelements und Substrates, bezogen auf die programmierte Platzierposition.

Diese Daten 66 erlauben dann die automatische Lagekorrektur 67 durch eine in der Platziervorrichtung 100 enthaltene Justiervorrichtung, welche Bewegungen in den Raumrichtungen X, Y, Z und / oder den Drehrichtungen βx, βy, βz ermöglicht.

Ausgehend von den entzerrten Bildern 35', 33' wird parallel zur Verarbeitung im Bilderkennungssystem ein Ausgabedatensatz 40 in Form überlagerter Bilder generiert. Die Erzeugung des Ausgabedatensatzes 40 geschieht analog der Darstellung und Beschreibung in Figur 3. Zusätzlich finden hier die durch die Bilderkennung gewonnenen Lagekorrekturdaten der einzelnen Platzierpartner als weitere Parameter bei der Ausführung des Algorithmus zur Erzeugung des Ausgabedatensatzes 40 Anwendung.

Der Ausgabedatensatz 40 zeigt somit das zu erwartende Platzierergebnis des Bauelements 2 auf einem Substrat 1, bezogen auf die programmierte Platzierposition an, obwohl die berechnete Lagekorrektur des Bilderkennungssystems von der Justiervorrichtung noch nicht ausgeführt wurde.

Der Ausgabedatensatz 40 kann analog zur Beschreibung in Fig. 3 in der Ausgabevorrichtung 70 angezeigt und / oder abgespeichert werden.

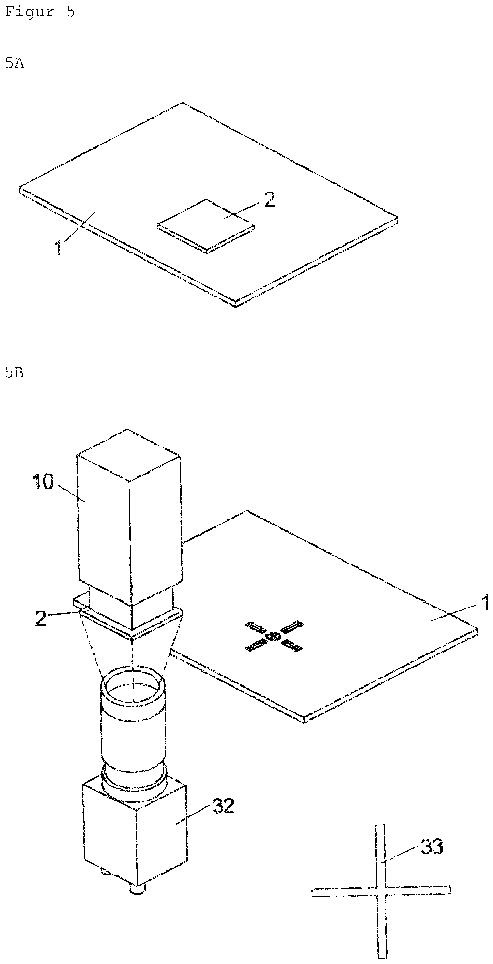

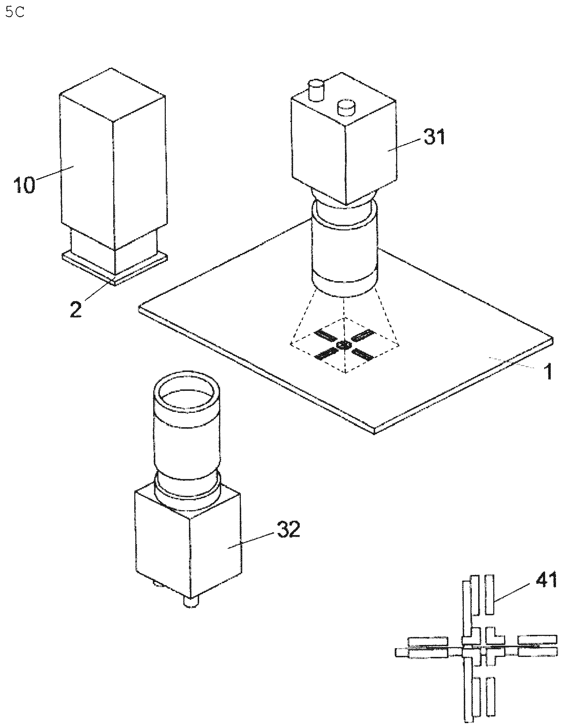

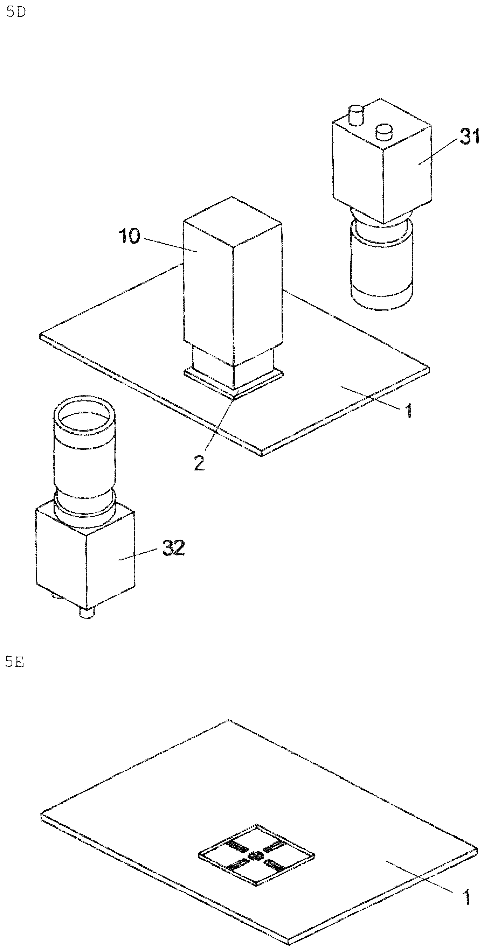

**In** **Figur 5** werden in den Teilabbildungen Fig. 5A bis 5E unterschiedliche Stadien der Platzierung eines Bauelementes 2 auf einem Substrat 1 dargestellt. Ein solches Platzierverfahren ist z.B. mit einer Platziervorrichtung 100 gemäß Fig. 1 oder Fig. 2 möglich.

In Fig. 5A ist das gewünschte Platzierergebnis dargestellt. Dabei wird davon ausgegangen, dass das Bauelement 2 mit den Kontakten nach unten zeigend ("face-down") auf dem Substrat 1 angeordnet wird.

Nachdem die Platziereinheit 10 (Fig. 1 / Fig. 2) ein Bauelement 2 vom Ablagebereich 22 (Fig. 1 / Fig. 2) entnommen hat, werden Bauelement 2 und Bauelementkameravorrichtung 32 zueinander bewegt (Fig. 5B), und die Bauelementkameravorrichtung 32 nimmt ein Bild 33 von der Unterseite des Bauelementes 2 auf.

Auf dem Substrat 1 ist die Position erkennbar, auf die das Bauelement 2 aufgesetzt werden soll.

Im nächsten Schritt (Fig. 5C) wird diese Position von der Substratkameravorrichtung 31 aufgenommen und ein Bild der Substratposition gewonnen.

Wenn nun das durch die Bauelementkameravorrichtung 32 aufgenommene Bild 33 des Bauelementes und das mit der Substratkameravorrichtung 31 aufgenommene Bild des Substrates dem Verfahren zum Erzeugen des Ausgabedatensatzes 40 analog Fig. 3 zugeführt werden, dann liegt ein überlagertes Bild 41 vor, welches auf der Ausgabevorrichtung 70 angezeigt wird. Dabei können sowohl bestimmte Fehler der Bilder 35, 33 als auch deren Überlagerungsposition zueinander zuvor durch Korrekturmittel 81, 82 korrigiert werden, wie in Fig. 3 und Fig. 4 zuvor beschrieben.

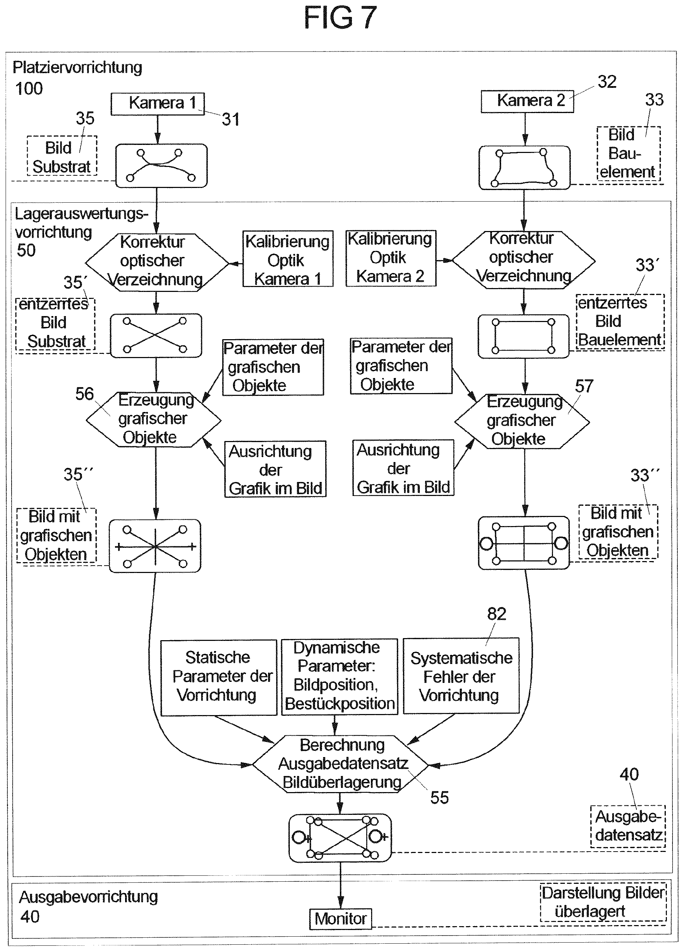

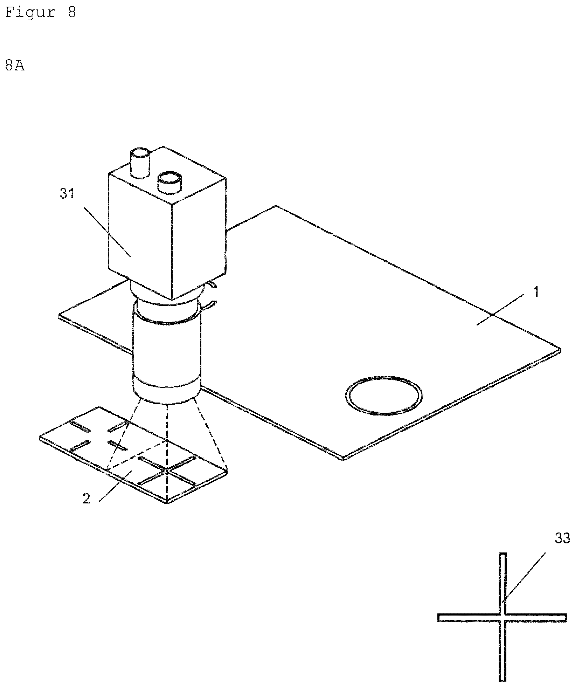

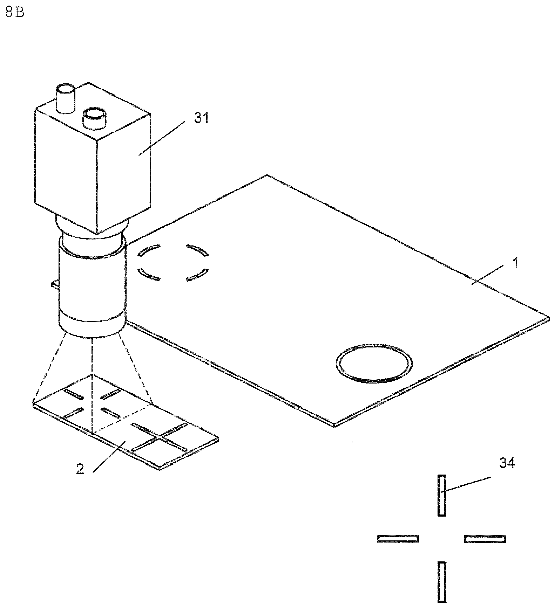

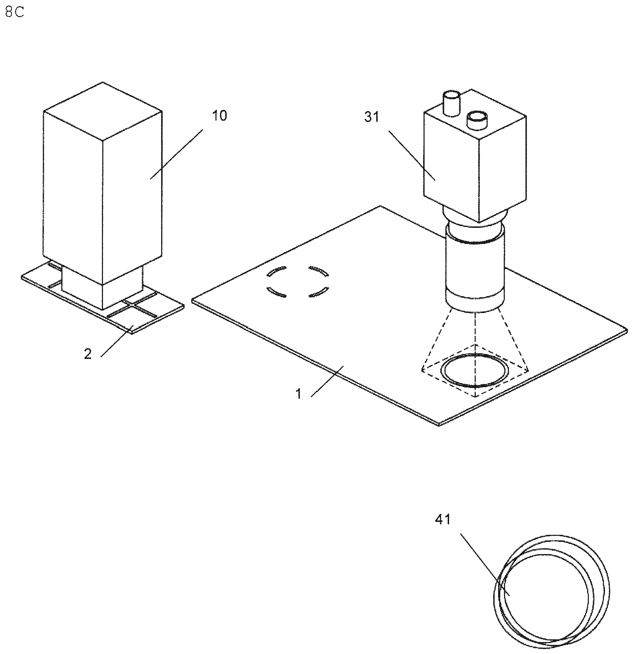

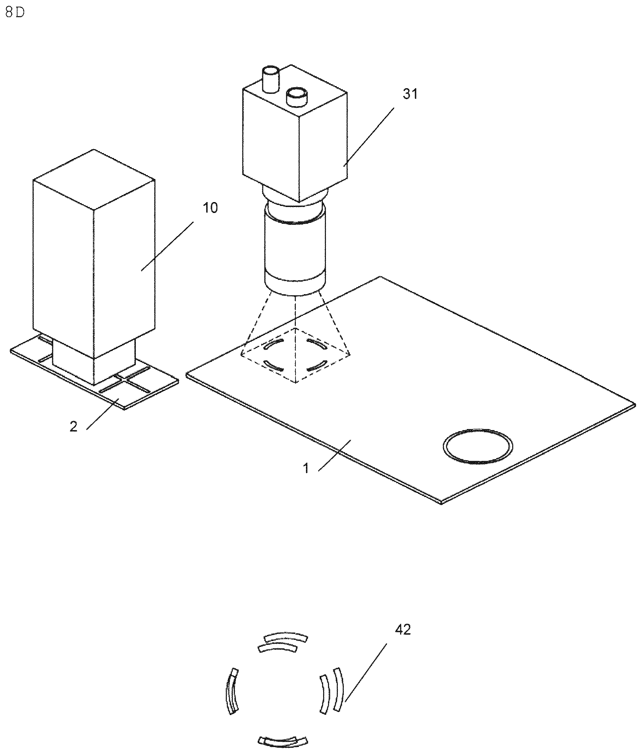

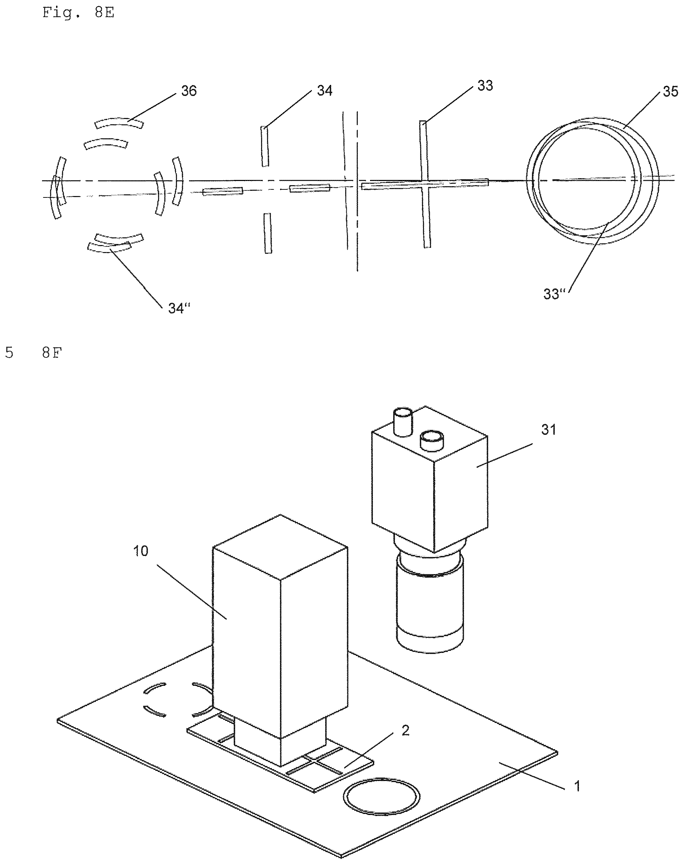

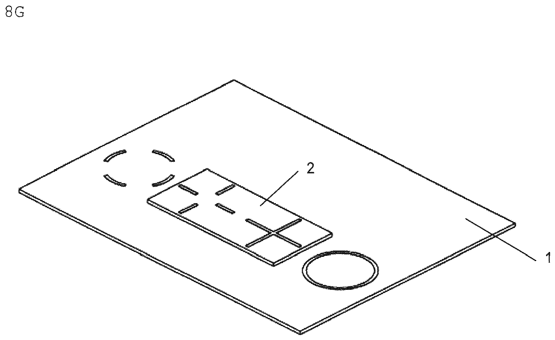

Der Anlagenbediener kann das zu erwartende Platzierergebnis somit anhand des überlagerten Bildes 41 sehen und beurteilen, obwohl die Teilbilder nicht zu gleichen Zeiten aufgenommen wurden. Solange die angezeigte Platzierposition nicht den Anforderungen entspricht, sollte die Ausrichtung von Bauelement zu Substrat mit Hilfe einer Justiervorrichtung verbessert werden. Hierzu können Verfahren nach Fig. 7 oder Fig. 8 angewendet werden.

Anschließend (Fig. 5D) wird die endgültige Platzierposition angefahren, und die Platziereinheit 10 platziert das Bauelement auf dem Substrat.

In Fig. 5E ist das endgültige Platzierergebnis dargestellt, wobei das Bauelement 2 hier transparent dargestellt ist.

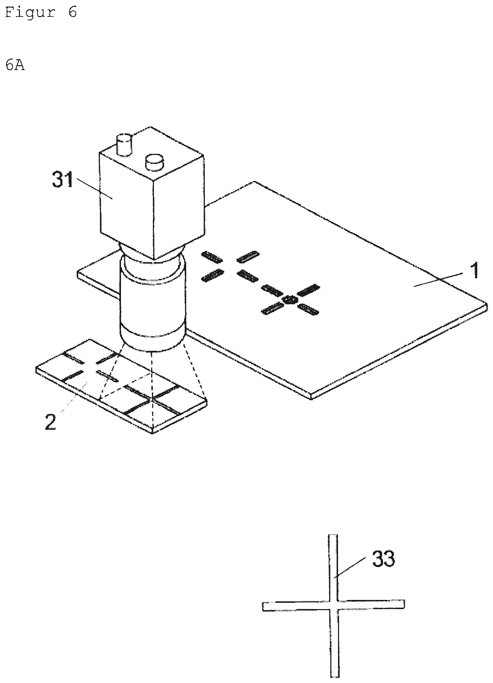

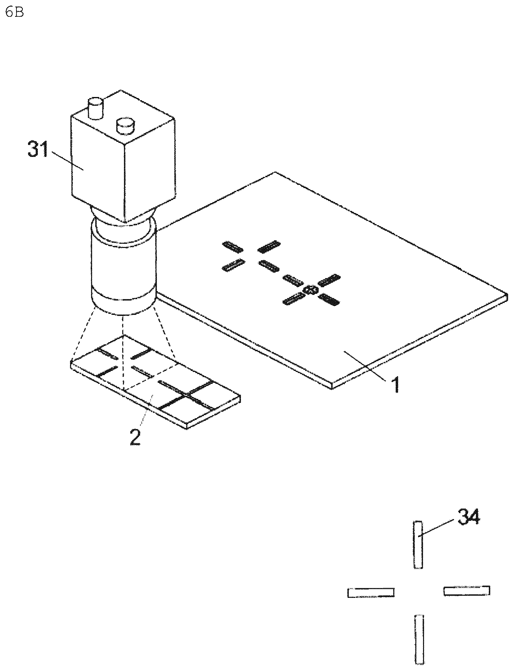

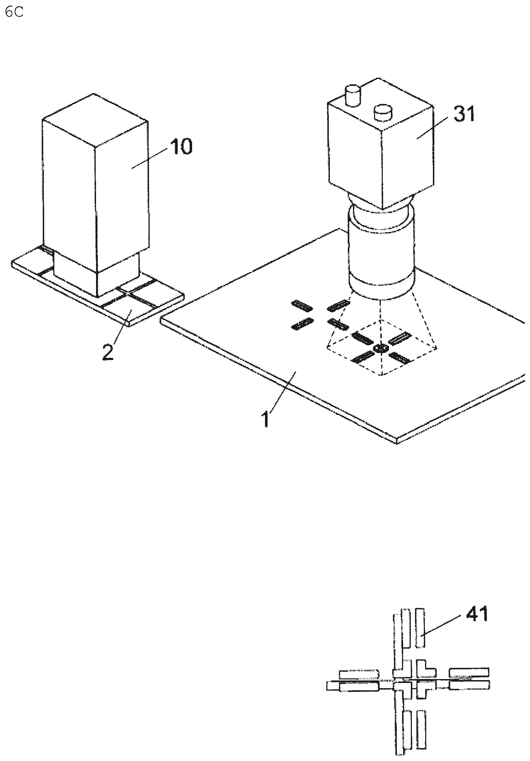

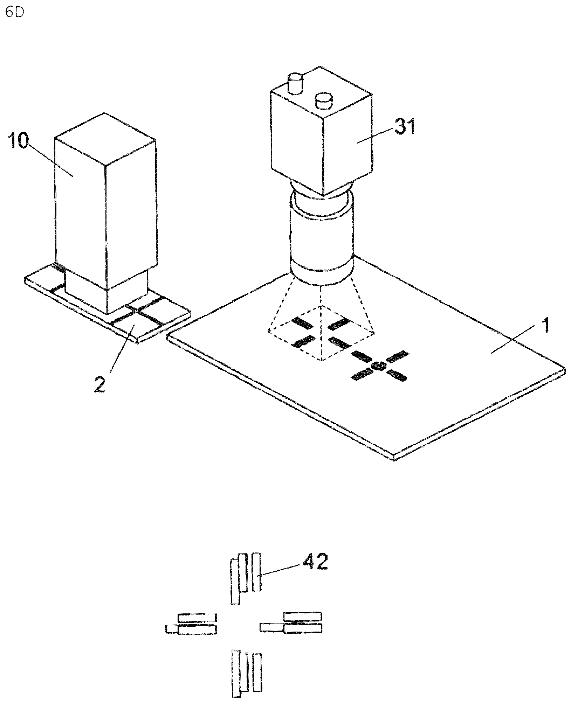

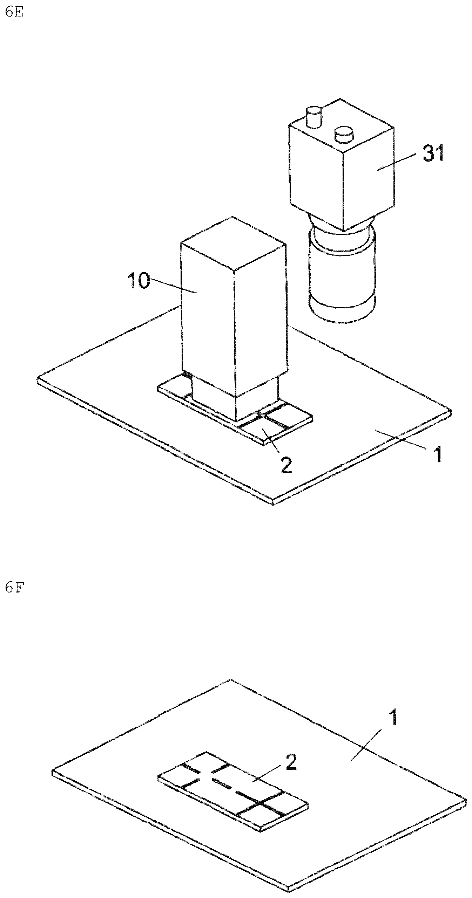

**In** **Fig. 6**A bis 6F wird eine Ausführungsform eines Platzierverfahrens beschrieben, welche sich von der Ausführungsform aus Fig. 5 dahingehend unterscheidet, dass hier ein größeres Bauelement 2 verwendet wird. Dies bedeutet, dass die Kameravorrichtung 31 das Bild 33 des Bauelementes 2 nicht aus einer Position aufnehmen kann. Außerdem wird das Bauelement 2 hier in einer "face-up" Orientierung auf einem Substrat 1 platziert, d.h. die Bauelementoberseite wird zur Oberseite des Substrats 1 ausgerichtet. Damit können alle Einzelbilder sowohl des Substrates 1 als auch des Bauelementes 2 mit einer einzigen Kameravorrichtung 31, aufgenommen werden, was aber nicht zwingend notwendig ist.

In Fig. 6A nimmt eine Kameravorrichtung 31 ein erstes Bild 33 des Bauelementes 2 von einer ersten Position auf.

In Fig. 6B ist dargestellt, dass die Kameravorrichtung und / oder das Bauelement so verfahren wurden, dass die Kameravorrichtung 31 ein zweites Bild 34 einer anderen Stelle des Bauelementes 2 aufnimmt. Es sei angemerkt, dass sich in diesem Fall das zweite Bild 34 des Bauelementes 2 vom ersten Bild 33 unterscheidet, was nicht immer der Fall sein muss.

Da das Bauelement 2 größer ist, ist auch die Platzierposition auf dem Substrat 1 größer.

In Fig. 6C wird von der Kameravorrichtung 31 von einer ersten Position eine erste Aufnahme der Substratposition gemacht. Die Überlagerung dieses Bildes mit dem ersten zuvor vom Bauelement 2 aufgenommenen Bild 33 ergibt im Ausgabedatensatz 40 ein erstes überlagertes Bild 41.

In Fig. 6D wird dann dieser Vorgang an einer zweiten Substratposition wiederholt. Hier ergibt sich im Ausgabedatensatz 40 ein zweites überlagertes Bild 42. Dieser Vorgang könnte an beliebig vielen weiteren Kamerapositionen wiederholt werden.

Der Ausgabedatensatz 40, zusammengesetzt aus den überlagerten Bildern 41, 42 und möglicherweise weiteren Bildern, kann dem Anlagenbediener angezeigt werden, wobei geeignete Werkzeuge zur Darstellung der Gesamtansicht bzw. interessierender Teilausschnitte des Ausgabedatensatzes zu Verfügung stehen (Beschreibung analog Fig. 3). Des Weiteren können auch hier einige oder alle aufgenommenen Bilder 33, 34 usw. Korrekturen durch Korrekturmittel 81, 82 unterworfen werden.

Anschließend (Fig. 6E) wird die endgültige Platzierposition angefahren und die Platziereinheit 10 platziert das Bauelement 2 auf dem Substrat 1.

In Fig. 6F ist das endgültige Platzierergebnis dargestellt.

**Figur 7** zeigt eine Ausführungsform einer Platziervorrichtung mit einer Lageauswertungsvorrichtung 50 mit einem Mittel zur Anzeige grafischer Objekte im Ausgabedatensatz 40. Hierzu werden in den Bildern der Platzierpartner entsprechende Objekte synthetisch erzeugt und durch spezifische Parameter beschrieben. Vorteilhafte synthetisch erzeugte geometrische Formen sind insbesondere Kreise, Ringe, Linien und Kreuze, beschreibende Parameter insbesondere Größe, Position und Farbe. Damit die grafischen Objekte eine geeignete Korrelation zum Bildinhalt aufweisen, ist es notwendig, diese einzeln oder als Gesamtgrafik relativ zum Bildinhalt auszurichten. Hierzu bietet die Platziervorrichtung 100 die Möglichkeit, durch einen Anlagenbediener die Ausrichtung vorzunehmen, beispielsweise durch Verschieben der Grafik in den angezeigten Bildern 35', 33'. Alternativ kann eine automatische Ausrichtung der Grafik durch die Anwendung der Ergebnisse eines Bilderkennungssystems erfolgen. Die eingefügten grafischen Objekte können sich dabei auch außerhalb des Eingangsbildes 35', 33' abbilden. In diesem Fall wird das Bild um den nötigen Bereich erweitert.

Die Nutzung grafischer Objekte im Bild ist eine Möglichkeit zur Kenntlichmachung spezifischer Positionen des Platzierpartners 1, 2, beispielsweise der Kontaktmittelpunkte eines Bauelementes 2 oder der Zentrumsposition einer Platzierposition auf dem Substrat 1. Insbesondere in Fällen, wo der Bildinhalt keine oder keine ausreichend erkennbaren Informationen an den signifikanten Bildstellen des jeweiligen Platzierpartners enthält, können grafische Objekte diesen Mangel an Bildinformation ausgleichen. Die Anwendung zur zusätzlichen Darstellung grafischer Objekte im Ausgabedatensatz 40 erweitert somit die Möglichkeiten zur Bewertung des Ausgabedatensatzes 40, da neben dem Bildinhalt auch die grafischen Objekte relativ zum Bildinhalt und / oder die grafischen Objekte zueinander beurteilt werden können.

Es ist zu bemerken, dass synthetische Objekte nicht zwangsläufig für beide Montagepartner erzeugt werden müssen. Meist sind sie nur für einen Montagepartner hilfreich.

**Fig. 8**A bis 8F enthält eine Ausführungsform eines Platzierverfahrens, welche die in Fig. 7 beschriebenen grafischen Objekte zwingend benötigt, um dem Maschinenbediener vorab das zu erwartende Platzierergebnis in Form geeigneter überlagerter Bilder 41, 42 darstellen zu können.

In Fig. 8 ist eine zu Fig. 6 analoge Ausführungsform eines Platzierverfahrens beschrieben, bei welcher sich allerdings die relativen Positionen, an denen die Einzelbilder von Bauelement und Substrat aufgenommen werden, nicht überdecken. Daher können auch die Bilder von Bauelement und Substrat nie direkt überlagert werden, sondern es sind zusätzlich die Erzeugung und Verwendung grafischer Objekte erforderlich.

In Fig. 8A und 8B nimmt die Kameravorrichtung 31, wie in Fig. 6A und 6B, ein erstes Bild 33 und ein zweites Bild 34 des Bauelementes 2 auf.

In Fig. 8C wird von der Kameravorrichtung 31 (von einer ersten Position eine erste Aufnahme der Substratposition gemacht.

Allerdings steht für diese Position kein vom Bauelement aufgenommenes Bild zur Überlagerung zur Verfügung, weil das Bauelement - wie in der Figur - zu klein dafür ist oder weil es an der komplementären Position keine zur Erkennung nutzbaren Strukturen aufweist. Daher werden auf Basis der vom Bauelement 2 aufgenommenen Bilder sowie weiterer Parameter grafische Objekte für die erforderlichen Substratpositionen synthetisch erzeugt, wobei sich die Bilder des Bauelementes 2 in ihrer Ausdehnung erweitern.

Die in ihrer Größe erweiterten und mit der grafischen Ringstruktur versehenen Bilder des Bauelementes 2 werden nachfolgend mit dem aktuellen Bild des Substrates 1 dem Algorithmus zur Erzeugung des Ausgabedatensatzes 40 zugeführt. Im Ausgabedatensatz 40 ergibt sich ein erstes überlagertes Bild 41.

In Fig. 8D wird dann dieser Vorgang an einer zweiten Substratposition wiederholt. Hier ergibt die Überlagerung der künstlich erzeugten Objekte und des aktuellen Substratbildes ein zweites überlagertes Bild 42.

Fig. 8E stellt einen Ausgabedatensatz 40 dar, wobei sich in der Überlagerung an den aufgenommenen Bildern der Substratposition 35, 36 die grafisch erzeugten Ringe vom Bauelementbild 33", 34" abbilden. In der Gesamtansicht ist auch die zu erwartende Lage des Bauelementes 2 durch die aufgenommenen Bauelementbilder 33, 34 erkennbar.

Der Ausgabedatensatz 40 kann wiederum in seiner Gesamtheit oder in Teilbereichen dem Anlagebediener angezeigt werden, wie dies im Zusammenhang mit den Figuren 5 und 6 beschrieben wurde, wobei wiederum alle aufgenommenen Bilder 33, 34 usw. Korrekturen durch Korrekturmittel 81, 82 unterworfen werden können.

Anschließend (Fig. 8F) wird die endgültige Platzierposition angefahren und die Platziereinheit 10 platziert das Bauelement 2 auf dem Substrat 1.

In Fig. 8G ist das endgültige Platzierergebnis dargestellt.

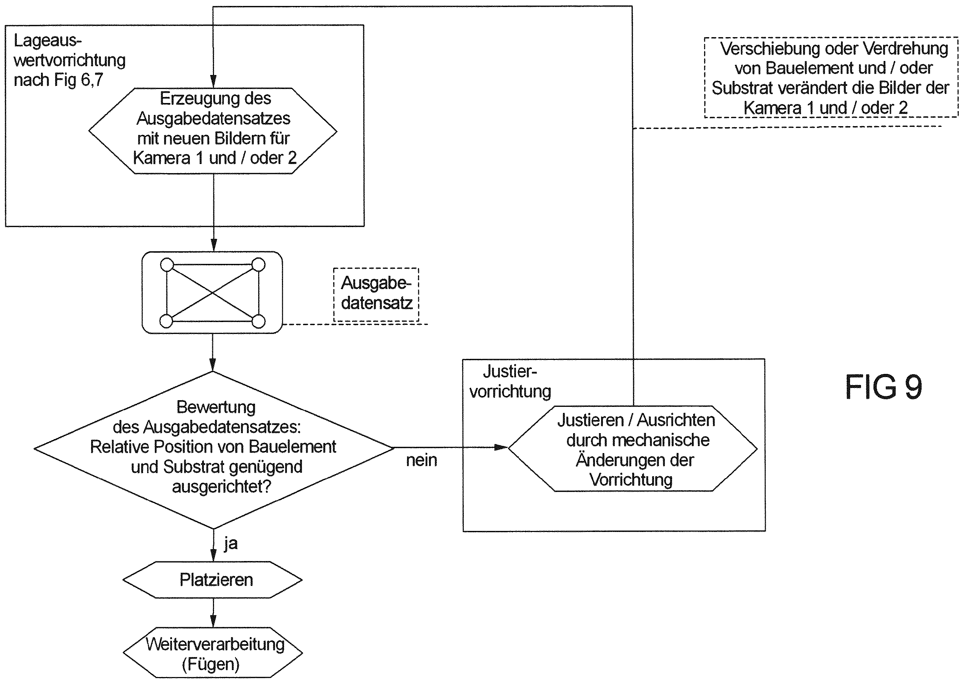

**Die** **Figur 9** stellt ein Blockschaltbild einer Ausführungsform einer Platziervorrichtung und eines damit auszuführenden Platzierverfahrens zum Justieren und Ausrichten der Position des Bauelementes 2 relativ zum Substrat 1 mittels Nachführung der beweglichen Achsen der Justiervorrichtung dar. Dies kann in einer Platziervorrichtung 100 implementiert sein.

Dabei kann die Platziervorrichtung 100 die Möglichkeit zur manuellen Korrektur der Position und / oder Drehung des Bauelementes 2 und / oder des Substrates 1 gewährleisten, beispielsweise durch einen Handsteuerungsbetrieb (Joystick) bei motorisierten Justiervorrichtungen und / oder durch manuelles Verschieben und / oder Verdrehen der Achsen der Justiervorrichtung durch den Bediener. In diesem Fall stellen die Mittel zum Handsteuerungsbetrieb z.B. Mittel zur räumlichen Einstellung des Bauelementes 2 und / oder des Substrates 1 dar.

Das Verfahren erzeugt immer wiederkehrend einen neuen Ausgabedatensatz 40 mit einem überlagerten Bild des Bauelements 2 zum Substrat 1 unter Anwendung der Korrekturmittel, sobald sich ein oder mehrere Kamerabilder auf Grund einer Anpassung der Justierung verändern.

In einer vorteilhaften Ausführungsform findet die Berechnung und Anzeige des Ausgabedatensatzes 40 in Echtzeit statt, so dass der Bediener in dem überlagerten Bild eine sofortige Veränderung seiner Justierung erkennt.

Eine Ausführungsform dieses Verfahrens ist die Aufnahme eines oder mehrerer Bilder von einem Bauelement 2, beispielsweise in einer Vorrichtung gemäß Figur 1 oder Figur 2. Anschließend erfolgt die Nachführung mindestens einer Achse, während die Kameravorrichtung 31 kontinuierlich Bilder von der Platzierposition aufnimmt. Der Ausgabedatensatz 40 wird jeweils durch die statischen Bilder des Bauelements 2 und durch sich verändernde Bilder des Substrates 1 erzeugt. Die Anwendung der Korrekturmittel bewirkt, dass der Bediener den Eindruck des aktuell zu erwartenden Platzierergebnisses in den überlagerten Bildern erhält, obwohl die Vorrichtung das Bauelement 2 nicht zwangsweise in der Platzierposition hält.

Eine zweite Ausführungsform dieses Verfahrens nach Fig. 9 besteht in der Aufnahme eines oder mehrerer Bilder eines Substrates 1 und der nachfolgenden Justierung während der kontinuierlichen Aufnahme von Bildern des Bauelementes 2. Die Funktion und Wirkungsweise sind analog der zuvor beschrieben Ausführungsform, nur mit dem Unterschied, dass der Ausgabedatensatz 40 jeweils durch die statischen Bilder des Substrates 1 und durch sich verändernde Bilder des Bauelementes 2 erzeugt wird.

Eine dritte Ausführungsform dieses Verfahrens nach Fig. 9 besteht in der gleichzeitigen kontinuierlichen Aufnahme von Bildern eines Substrates 1 und eines Bauelementes 2 während der Justierung. Die Funktion und Wirkungsweise sind analog wie zuvor beschrieben.

Nach positiver Bewertung des Ausgabedatensatzes 40, d.h. die visuelle Darstellung der relativen Position des Bauelementes 2 zum Substrat 1 ist ausreichend genau, kann eine Platzierung der Platzierpartner durch die Platziervorrichtung 100 erfolgen.

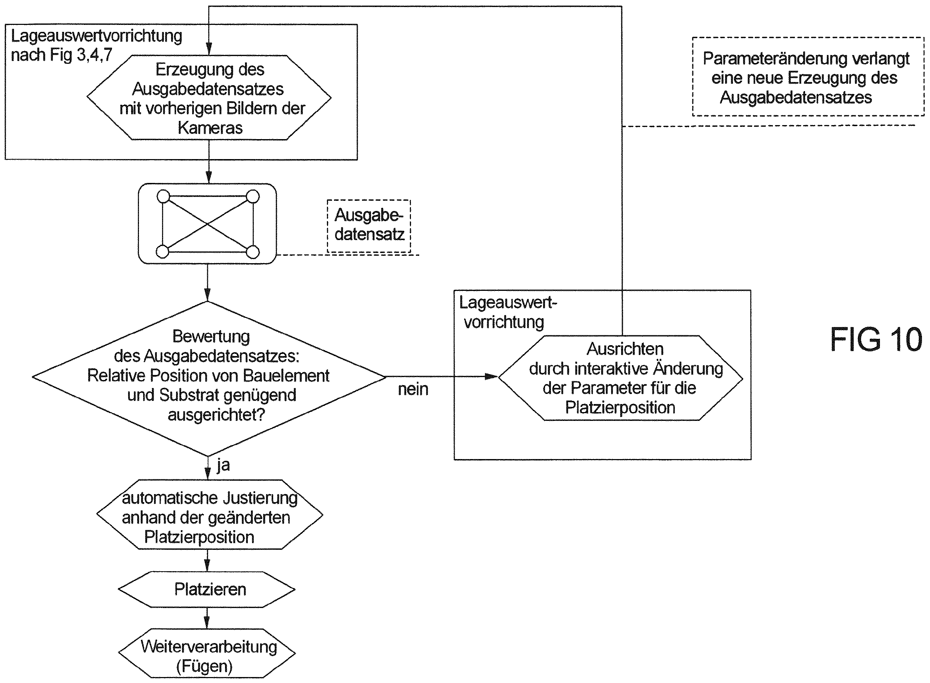

**Die** **Figur 10** stellt ein Blockschaltbild einer Ausführungsform einer Platziervorrichtung 100 und eines damit auszuführenden Platzierverfahrens zum Justieren und Ausrichten der Position des Bauelements 2 relativ zum Substrat 1 mittels Ausrichtung der visuellen Abbilder der Platzierpartner 1, 2 im Ausgabedatensatz 40 dar. Hierzu werden zunächst jeweils mindestens ein Bild eines Bauelements 2 und mindestens ein Bild eines Substrates 1 aufgenommen und dem Verfahren zur Erzeugung des Ausgabedatensatzes 40 gemäß Fig. 3, Fig. 4 oder Fig. 7 zugeführt. In dieser Ausführungsform erfolgt allerdings das Ausrichten durch Änderung der Parameter des Algorithmus des Ausgabedatensatzes 40. Eine geeignete Form könnte beispielsweise das Verschieben eines Teilbildes in der Darstellung des überlagerten Bildes mit Hilfe der Computermaus sein oder das diskrete Editieren von Werten in Eingabemasken. Jedwede Änderung der Parameter startet eine neue Berechnung des Ausgabedatensatzes 40, welcher anschließend dargestellt wird. Dem Anlagenbediener wird somit der Eindruck vermittelt, er könne die visuellen Abbilder des Bauelements 2 und Substrates 1 in dem überlagerten Bild zueinander ausrichten. Es ist zu bemerken, dass die Vorrichtung hierzu nicht bewegt werden muss und der Algorithmus immer mit den eingangs aufgenommenen Bildern arbeitet. Nach positiver Bewertung des Ausgabedatensatzes 40, d.h. die visuelle Darstellung der relativen Position des Bauelements 2 zum Substrat 1 ist ausreichend genau, erfolgt eine automatische Justierung der Platzierpartner 1, 2 durch die Platziervorrichtung 100. Hierzu werden die letzten gültigen Parameter bezüglich der Lage der visuellen Abbilder des Bauelements 2 und Substrates 1 in geeigneter Form in Bewegungskoordinaten der Platziervorrichtung 100 umgerechnet und angewendet. Anschließend kann das Absetzen erfolgen.

Allen beschriebenen Verfahren ist gemeinsam, dass dem Anlagenbediener ein Ausgabedatensatz 40 in Form von überlagerten Bildern angeboten wird. Damit kann eine Reihe von Vorteilen erreicht werden, welche im Folgenden angesprochen werden.

So ist eine einfache Musterbestückung ohne langwierige Vorab-Programmierung möglich. Der Anlagenbediener sieht das zu erwartende Ergebnis "live" und kann das Muster in einem "Manuellen Modus" bestücken: Der Anlagenbediener bewegt das Bauelement 2 "live" an die richtige Stelle des Substrates, so dass auf eine aufwändige Programmierung der Positionen und Bilderkennung verzichtet werden kann. Das Ausrichten kann dabei durch Anwendung der Verfahren gemäß Fig. 9 oder gemäß Fig. 10 realisiert werden.

Ferner werden mögliche Bestückungsfehler der Maschine bereits vor der Platzierung des Bauelements 2 sichtbar, denn ein Anlagenbediener ist in der Lage, in der Bildüberlagerung erkennbare Platzierfehler auf Fehlprogrammierungen im Prozessprogramm der Maschine, insbesondere der Platzierposition, zurückzuführen und bei Bedarf zu korrigieren.

Es kann eine wesentliche Zeitersparnis bei der Prozessprogramm-Erstellung gegenüber dem üblichen Weg unter ausschließlicher Nutzung von Geometriedaten / Zeichnungen erreicht werden.

Montagefehler sind visuell erkennbar, bevor die eigentliche Montage ausgeführt wird. Diese können vorrangig verursacht werden
- durch andere Fehler der Montagepartner, wenn z.B. ein Bauelement 2 im Lagerbereich 20 um 90° verdreht zugeführt wird
- wenn ein falsches Bauelement 2 zugeführt wird, das aber eine sehr ähnliche Geometrie aufweist
- durch eine zu große Streckung von flexiblen Montagepartnern, beispielweise von Kunststofffolien.

### Bezugszeichenliste

- 1: erster Platzierpartner, Substrat
- 2: zweiter Platzierpartner, Bauelement
- 2': Zweites Bauelement
- 2": Drittes Bauelement
- 2''': Viertes Bauelement, Ausrichte-Strukturen auf der Oberseite
- 3: Haltevorrichtung für Bauelement

- 10: Platziereinheit
- 11: Portal

- 20: Unterlage, Haltevorrichtung für Substrat
- 22: Lagerbereich für Bauelemente

- 31: erste Kameravorrichtung, Substratkameravorrichtung
- 32: zweite Kameravorrichtung, Bauelementkameravorrichtung
- 33: (Erstes) aufgenommene Bild des Bauelementes
- 33': Korrigiertes Bild des Bauelementes
- 33": Bild des Bauelementes mit grafischen Objekten
- 34: Zweites aufgenommenes Bild des Bauelementes
- 34": Zweites Bild des Bauelementes mit grafische Objekten

- 35: (Erstes) Bild Substrat
- 35': Korrigiertes Bild des Substrates
- 35": Bild des Substrates mit grafischen Objekten
- 36: Zweites aufgenommenes Bild des Substrates
- 36': Korrigiertes zweites Bild des Substrates

- 40: Ausgabedatensatz
- 41: Erstes überlagertes Bild des Ausgabedatensatzes
- 42: Zweites überlagertes Bild des Ausgabedatensatzes

- 50: Lageauswertungsvorrichtung
- 51: Korrekturschritt für Bild des Substrates
- 52: Korrekturschritt für Bild des Bauelementes
- 55: Berechnung des Ausgabedatensatz
- 56: Erzeugung grafischer Objekte im Bild des Substrates
- 57: Erzeugung grafischer Objekte im Bild des Bauelementes

- 60: Bilderkennungssystem
- 61: Bilderkennung Substrat
- 62: Bilderkennung Bauelement
- 63: Lagekorrekturdaten des Substrates
- 64: Lagekorrekturdaten des Bauelementes
- 65: Berechnung der Lagekorrekturdaten relativ zur Platzierposition
- 66: Lagekorrekturdaten beider Platzierpartner
- 67: Automatische Lagekorrektur

- 70: Ausgabevorrichtung

- 81: Erstes Korrekturmittel
- 82: Zweites Korrekturmittel

- 100: Platziervorrichtung

- X, Y, Z: Bewegungsmöglichkeiten in Raumrichtungen
- βₓ, β_{y}, β_{z}: Bewegungsmöglichkeiten um Raumachsen

## Patentansprüche

1. Platziervorrichtung zum lagegenauen Ausrichten und / oder Bestücken eines erstes Platzierpartners (1) mit mindestens einem dazu komplementären zweiten Platzierpartner (2),
umfassend mindestens eine Kameravorrichtung (31, 32) zur Aufnahme von separaten Bildern (33, 35) des ersten Platzierpartners (1) oder einer Haltevorrichtung des ersten Platzierpartners (1) und des mindestens einen zweiten Platzierpartners (2) oder einer Haltevorrichtung (3) für den mindestens einen zweiten Platzierpartner (2) und
eine Lageauswertungsvorrichtung (50) die eingerichtet ist zur Erstellung eines Ausgabedatensatzes (40) aus einer Verarbeitung der zuvor gewonnenen Bilder (33, 35), wobei der Ausgabedatensatz (40) aus einer Verarbeitung der zuvor gewonnenen Bilder eine Überlagerung der Bilder zur Anzeige auf einer Ausgabevorrichtung aufweist und das zu erwartende Platzierergebnis der Vorrichtung visualisiert, nämlich umfassend ein Bild, welches aus mehreren überlagerten Kamerabildern besteht, basierend auf dem Zustand der Platziervorrichtung zum jeweiligen Zeitpunkt der Bildaufnahme der Bilder (35', 33'),
eine Justiervorrichtung eingerichtet zur relativen Ausrichtung von erstem Platzierpartner (1) und dem mindestens einen zweiten Platzierpartner (2) zueinander in mindestens einer Raumrichtung und / oder Drehrichtung, und
wobei die Platziervorrichtung Korrekturmittel (82) aufweist, um systematische Fehler der Platziervorrichtung (100), wie Linearitätsabweichungen in Achsen und Führungen aufgrund mechanischer Toleranzen und / oder durch Temperatureinflüsse, zu verrechnen,
wobei die Vorrichtung eingerichtet ist zur Erstellung und Anzeige des Ausgabedatensatzes (40) in Echtzeit, so dass ein Anlagenbediener in die Lage versetzt wird, interaktiv das Ausrichten der Platzierpartner (1, 2) anhand der visuellen Darstellung des zu erwartenden Platzierergebnisses durchzuführen, wobei die Platziervorrichtung (100) Mittel zur manuellen Korrektur der Position und / oder Drehung der Platzierpartner (1, 2) umfasst, beispielsweise durch einen Handsteuerungsbetrieb (Joystick) bei motorisierten Justiervorrichtungen und / oder durch manuelles Verschieben und / oder Verdrehen der Achsen der Justiervorrichtung durch den Anlagenbediener,
wobei die Vorrichtung eingerichtet ist für ein Ausrichten und Justieren der Platzierpartner (1, 2) durch ein Mittel zum Einstellen der visuellen Abbilder des ersten Platzierpartners (1) und / oder des mindestens einen zweiten Platzierpartners (2) im Ausgabedatensatz (40), wobei das Ausrichten beispielsweise durch Verschieben eines Teilbildes in der Darstellung des überlagerten Bildes mit Hilfe der Computermaus erfolgt, wobei die Vorrichtung nicht bewegt und der Algorithmus immer mit den eingangs aufgenommenen Bildern arbeitet, und wobei zum automatischen Justieren der Platzierpartner (1, 2) die letzten gültigen Parameter bezüglich der Lage der visuellen Abbilder des Bauelements und Substrates in geeigneter Form in Bewegungskoordinaten der Platziervorrichtung umgerechnet werden.

2. Platziervorrichtung nach Anspruch 1, **gekennzeichnet dadurch, dass** der erste Platzierpartner (1) ein Substrat und der mindestens zweite Platzierpartner (2) mindestens ein Bauelement aufweist.

3. Platziervorrichtung nach Anspruch 1 oder 2, **gekennzeichnet durch** eine zweite Kameravorrichtung (32) zur Aufnahme von Bildern des zweiten Platzierpartners (2) und eine erste Kameravorrichtung (31) zur Aufnahme von Bildern des mindestens ersten Platzierpartners (1).

4. Platziervorrichtung nach mindestens einem der vorhergehenden Ansprüche, **gekennzeichnet durch** ein erstes Korrekturmittel (81) für die Bilder der Kameravorrichtungen (31, 32) mittels Kalibrierdaten zur Minimierung der optischen Fehler, insbesondere Verzeichnungen.

5. Platziervorrichtung nach mindestens einem der vorhergehenden Ansprüche, **gekennzeichnet durch** ein Mittel zur Erzeugung und Anzeige grafischer Objekte, mit dem in den Bildern der Platzierpartner (1, 2) entsprechende Objekte synthetisch erzeugt, durch spezifische Parameter beschrieben und einzeln oder als Gesamtgrafik relativ zum Bildinhalt ausgerichtet werden, wobei die Vorrichtung eingerichtet ist die graphischen Objekte im Bild zur Kenntlichmachung spezifischer Positionen der Platzierpartner (1, 2) zu nutzen, wobei das mit den graphischen Objekten versehene Bild des einen Platzierpartners mit dem Bild des anderen Platzierpartners überlagert wird und so anhand der grafischen Objekte eine Justage der Platzierpartner (1, 2) vorgenommen werden kann.

6. Platziervorrichtung nach mindestens einem der vorhergehenden Ansprüche, **dadurch gekennzeichnet, dass** die Ergebnisse eines an die Platziervorrichtung gekoppelten automatischen Bilderkennungssystems (60) bei der Erstellung des Ausgabedatensatzes (40) mitverarbeitet werden.

7. Platziervorrichtung nach mindestens einem der vorhergehenden Ansprüche, **gekennzeichnet durch** Mittel zur Weiterverarbeitung des ersten und zweiten Platzierpartners (1, 2), insbesondere einem Mittel zur Herstellung einer dauerhafteren Verbindung der Platzierpartner (1, 2) durch Thermokompression, Ultraschallverfahren, Löten und / oder Kleben.

8. Platzierverfahren für eine Platziervorrichtung (100) zum lagegenauen Ausrichten und / oder Bestücken eines ersten Platzierpartners (1) mit mindestens einem dazu komplementären zweiten Platzierpartner (2), wobei
a) mindestens eine Kameravorrichtung (31, 32) jeweils mindestens ein separates Bild (33, 35) des ersten Platzierpartners (1) oder einer Haltevorrichtung des ersten Platzierpartners (1) und des mindestens einen zweiten Platzierpartners (2) oder einer Haltevorrichtung (3) des mindestens einen zweiten Platzierpartners (2) aufnimmt,
b) eine Lageauswertungsvorrichtung (50) einen Ausgabedatensatz (40) aus einer Verarbeitung der zuvor gewonnenen Bilder (33, 35) erstellt, wobei
c) der Ausgabedatensatz (40) aus einer Verarbeitung der zuvor gewonnenen Bilder eine Überlagerung der Bilder zur Anzeige auf einer Ausgabevorrichtung aufweist und das zu erwartenden Platzierergebnis visualisiert, nämlich umfassend ein Bild, welches aus mehreren überlagerten Kamerabildern besteht, basierend auf dem Zustand der Platziervorrichtung zum jeweiligen Zeitpunkt der Bildaufnahme der Bilder (35', 33'),
d) mittels einer Justiervorrichtung eine relative Ausrichtung von erstem Platzierpartner (1) und dem mindestens einen zweiten Platzierpartner (2) zueinander in mindestens einer Raumrichtung und / oder Drehrichtung erfolgt,
e) mittels Korrekturmitteln (82) systematische Fehler der Platziervorrichtung (100), wie Linearitätsabweichungen in Achsen und Führungen aufgrund mechanischer Toleranzen und / oder durch Temperatureinflüsse verrechnet werden,
f) die Erstellung und Anzeige des Ausgabedatensatzes (40) in Echtzeit erfolgt, so dass ein Anlagenbediener in die Lage versetzt wird, interaktiv das Ausrichten der Platzierpartner (1, 2) anhand der visuellen Darstellung des zu erwartenden Platzierergebnisses durchzuführen, wobei die Platziervorrichtung (100) Mittel zur manuellen Korrektur der Position und / oder Drehung der Platzierpartner (1, 2) umfasst, beispielsweise durch einen Handsteuerungsbetrieb (Joystick) bei motorisierten Justiervorrichtungen und / oder durch manuelles Verschieben und / oder Verdrehen der Achsen der Justiervorrichtung durch den Anlagenbediener, und
g) das Ausrichten und Justieren der Platzierpartner (1, 2) durch ein Mittel zum Einstellen der visuellen Abbilder der ersten und zweiten Platzierpartner (1, 2) im Ausgabedatensatz (40) erfolgt, wobei das Ausrichten beispielsweise durch Verschieben eines Teilbildes in der Darstellung des überlagerten Bildes mit Hilfe der Computermaus erfolgt, wobei die Vorrichtung nicht bewegt und der Algorithmus immer mit den eingangs aufgenommenen Bildern arbeitet, und wobei zum automatischen Justieren der Platzierpartner (1, 2) die letzten gültigen Parameter bezüglich der Lage der visuellen Abbilder des Bauelements und Substrates in geeigneter Form in Bewegungskoordinaten der Platziervorrichtung umgerechnet werden.

## Claims

1. Placement apparatus for aligning and/or equipping with positional accuracy a first placement partner (1) with at least one second placement partner (2), complementary thereto, comprising
at least one camera apparatus (31, 32) for recording separate images (33, 35) of the first placement partner (1), or a holding apparatus of the first placement partner (1), and the at least one second placement partner (2), or a holding apparatus (3) for the at least one second placement partner (2), and
a relative position evaluation apparatus (50), which is configured to create an output data record (40) from processing the previously obtained images (33, 35), wherein the output data record (40), from processing the previously obtained images, comprises an overlay of the images for displaying on an output apparatus and visualizes the expected placement result of the apparatus, specifically comprising an image consisting of a plurality of overlaid camera images on the basis of the state of the placement apparatus at the respective time of the image recording of the images (35', 33'),
an adjustment apparatus, which is configured for relative alignment of the first placement partner (1) and at least one second placement partner (2) to one another in at least one spatial direction and/or rotational direction, and
wherein the placement apparatus comprises correction means (82) for offset systematic errors of the placement apparatus (100), such as linearity deviations in shafts and guides on account of mechanical tolerances and/or due to the influence of temperature,
wherein the apparatus is configured to create and display the output data record (40) in real-time such that an operator of the installation is enabled to carry out the alignment of the placement partners (1, 2) interactively on the basis of visual presentation of the expected placement result, wherein the placement apparatus (100) comprises means for the manual correction of the position and/or rotation of the placement partners (1, 2), for example by way of a manual control operation (joysticks) in the case of motor-driven adjustment apparatuses and/or by a manual displacement and/or twist of the shafts of the adjustment apparatus by the operator of the installation,
wherein the apparatus is configured for alignment and adjusting the placement partners (1, 2) by way of a means for setting the visual image representations of the first placement partner (1) and/or the at least one second placement partner (2) in the output data record (40), wherein the alignment is implemented, for example, by displacing a partial image in the representation of the overlaid image with the aid of the computer mouse, wherein the apparatus is not moved and the algorithm always operates with the images recorded at the outset, and wherein, for the purposes of automatically adjusting the placement partners (1, 2), the last valid parameters in respect of the relative position of the visual image representations of the component and of the substrate are converted in a suitable form into movement coordinates of the placement apparatus.

2. Placement apparatus according to Claim 1, **characterized in that** the first placement partner (1) comprises a substrate and the at least one second placement partner (2) comprises at least one component.

3. Placement apparatus according to Claim 1 or 2, **characterized by** a second camera apparatus (32) for recording images of the second placement partner (2) and a first camera apparatus (31) for recording images of the at least one first placement partner (1).

4. Placement apparatus according to at least one of the preceding claims, **characterized by** a first correction means (81) for the images of the camera apparatuses (31, 32) by means of calibration data for the purposes of minimizing the optical aberrations, in particular distortions.

5. Placement apparatus according to at least one of the preceding claims, **characterized by** a means for generating and displaying graphical objects, by means of which, in the images of the placement partners (1, 2), corresponding objects are synthetically generated, described by specific parameters and aligned individually or as an overall graphics relative to the image content, wherein the apparatus is configured to use graphical objects in the image for identifying specific positions of the placement partners (1, 2), wherein the image of the one placement partner, provided with graphical objects, is overlaid on the image of the other placement partner and thus the placement partners (1, 2) can be adjusted on the basis of the graphical objects.

6. Placement apparatus according to at least one of the preceding claims, **characterized in that** the results of an automatic image detection system (60), which is coupled to the placement apparatus, are also processed when creating the output data record (40).

7. Placement apparatus according to at least one of the preceding claims, **characterized by** means for further processing of the first and second placement partner (1, 2), in particular a means for creating a permanent connection of the placement partner (1, 2) by way of thermocompression, ultrasonic methods, soldering and/or adhesive bonding.

8. Placement method for a placement apparatus (100) for aligning and/or equipping with positional accuracy a first placement partner (1) with at least one second placement partner (2), complementary thereto, wherein
a) at least one camera apparatus (31,32) in each case records at least one separate image (33, 35) of the first placement partner (1), or a holding apparatus of the first placement partner (1), and the at least one second placement partner (2), or a holding apparatus (3) for the at least one second placement partner (2),
b) a relative position evaluation apparatus (50) creates an output data record (40) from processing the previously obtained images (33, 35), wherein
c) the output data record (40), from processing the previously obtained images, comprises an overlay of the images for displaying on an output apparatus and visualizes the expected placement result of the apparatus, specifically comprising an image consisting of a plurality of overlaid camera images on the basis of the state of the placement apparatus at the respective time of the image recording of the images (35', 33'),
d) an adjustment apparatus is used for a relative alignment of the first placement partner (1) and at least one second placement partner (2) to one another in at least one spatial direction and/or rotational direction,
e) correction means (82) are used to offset systematic errors of the placement apparatus (100), such as linearity deviations in shafts and guides on account of mechanical tolerances and/or due to the influence of temperature,
f) the creation and displaying of the output data record (40) is performed in real-time such that an operator of the installation is enabled to carry out the alignment of the placement partners (1, 2) interactively on the basis of visual presentation of the expected placement result, wherein the placement apparatus (100) comprises means for the manual correction of the position and/or rotation of the placement partners (1, 2), for example by way of a manual control operation (joysticks) in the case of motor-driven adjustment apparatuses and/or by a manual displacement and/or twist of the shafts of the adjustment apparatus by the operator of the installation, and
g) the alignment and adjusting of the placement partners (1, 2) is performed by a means for setting the visual image representations of the first and second placement partners (1, 2) in the output data record (40), wherein the alignment is implemented, for example, by displacing a partial image in the representation of the overlaid image with the aid of the computer mouse, wherein the apparatus is not moved and the algorithm always operates with the images recorded at the outset, and wherein, for the purposes of automatically adjusting the placement partners (1, 2), the last valid parameters in respect of the relative position of the visual image representations of the component and of the substrate are converted in a suitable form into movement coordinates of the placement apparatus.

## Revendications

1. Dispositif de placement servant à aligner et/ou à équiper avec précision un premier partenaire de placement (1) avec au moins un deuxième partenaire de placement complémentaire (2) de celui-ci, comprenant au moins un dispositif à caméra (31, 32) servant à acquérir des images séparées (33, 35) du premier partenaire de placement (1) ou d'un dispositif de maintien du premier partenaire de placement (1) et dudit au moins un deuxième partenaire de placement (2) ou d'un dispositif de maintien (3) destiné audit au moins un deuxième partenaire de placement (2) et
un dispositif d'évaluation de position (50) qui conçu pour créer un jeu de données de sortie (40) à partir d'un traitement des images précédemment obtenues (33, 35), dans lequel le jeu de données de sortie (40) issu d'un traitement des images précédemment obtenues présente une superposition des images pour leur affichage sur un dispositif de sortie et visualise le résultat de placement attendu du dispositif, à savoir comprenant une image constituée d'une pluralité d'images de caméra superposées sur la base de l'état du dispositif de placement à l'instant respectif de l'acquisition des images (35', 33'),
un dispositif d'ajustement conçu pour l'alignement relatif du premier partenaire de placement (1) et dudit au moins un deuxième partenaire de placement (2) l'un par rapport à l'autre dans au moins une direction spatiale et/ou une direction de rotation, et
dans lequel le dispositif de placement comporte des moyens de correction (82) servant à calculer des erreurs systématiques du dispositif de placement (100), telles que des écarts de linéarité dans des axes et des guides, dus à des tolérances mécaniques et/ou à des effets de température,
dans lequel le dispositif est conçu pour créer et afficher le jeu de données de sortie (40) en temps réel, de sorte qu'un opérateur du système est en mesure d'effectuer de manière interactive l'alignement des partenaires de placement (1, 2) à l'aide de la représentation visuelle du résultat de placement attendu, dans lequel le dispositif de placement (100) comprend des moyens servant à corriger manuellement la position et/ou la rotation des partenaires de placement (1, 2), par exemple par une opération de commande manuelle (joystick) dans le cas de dispositifs d'ajustement motorisés et/ou par un décalage et/ou une rotation manuels des axes du dispositif d'ajustement par l'opérateur du système,
dans lequel le dispositif est conçu pour aligner et ajuster les partenaires de placement (1, 2) à l'aide d'un moyen de réglage servant à régler les images visuelles du premier partenaire de placement (1) et/ou dudit au moins un deuxième partenaire de placement (2) dans le jeu de données de sortie (40), dans lequel l'alignement est réalisé, par exemple, en décalant une image partielle dans la représentation de l'image superposée à l'aide de la souris de l'ordinateur, dans lequel le dispositif ne se déplace pas et l'algorithme fonctionne toujours avec les images acquises en entrée, et dans lequel, pour l'ajustement automatique des partenaires de placement (1, 2), les derniers paramètres valables relatifs à la position des images visuelles du composant et du substrat sont convertis sous une forme appropriée en coordonnées de déplacement du dispositif de placement.

2. Dispositif de placement selon la revendication 1, **caractérisé en ce que** le premier partenaire de placement (1) comprend un substrat et ledit au moins un deuxième partenaire de placement (2) comprend au moins un composant.

3. Dispositif de placement selon la revendication 1 ou 2, **caractérisé par** un deuxième dispositif à caméra (32) servant à acquérir des images du deuxième partenaire de placement (2) et un premier dispositif à caméra (31) servant à acquérir des images dudit au moins premier partenaire de placement (1).

4. Dispositif de placement selon au moins l'une des revendications précédentes, **caractérisé par** un premier moyen de correction (81) destiné aux images des dispositifs de caméra (31, 32) au moyen de données d'étalonnage pour minimiser les erreurs optiques, en particulier les distorsions.

5. Dispositif de placement selon au moins l'une des revendications précédentes, **caractérisé par** un moyen servant à générer et à afficher des objets graphiques, avec lequel, dans les images, des partenaires de placement (1, 2) d'objets correspondants sont générés de manière synthétique, sont décrits par des paramètres spécifiques et sont alignés individuellement ou sous forme de graphique global par rapport au contenu de l'image, dans lequel le dispositif est conçu pour utiliser les objets graphiques de l'image afin d'identifier des positions spécifiques des partenaires de placement (1, 2), dans lequel l'image dudit un partenaire de placement qui est dotée des objets graphiques est superposée à l'image de l'autre partenaire de placement, un ajustement des partenaires de placement (1, 2) pouvant ainsi être effectué sur la base des objets graphiques.

6. Dispositif de placement selon au moins l'une des revendications précédentes, **caractérisé en ce que** les résultats d'un système de reconnaissance automatique d'images (60) couplé au dispositif de placement sont traités conjointement lors de la création du jeu de données de sortie (40).

7. Dispositif de placement selon au moins l'une des revendications précédentes, **caractérisé par** des moyens de post-traitement des premier et deuxième partenaires de placement (1, 2), en particulier par un moyen destiné à établir une liaison plus durable des partenaires de placement (1, 2) par thermocompression, procédé par ultrasons, soudage et/ou collage.

8. Procédé de placement destiné à un dispositif de placement (100) servant à aligner et/ou équiper avec précision un premier partenaire de placement (1) avec au moins un deuxième partenaire de placement complémentaire (2) de celui-ci, dans lequel
a) au moins un dispositif de caméra (31, 32) acquiert respectivement au moins une image séparée (33, 35) du premier partenaire de placement (1) ou d'un dispositif de maintien du premier partenaire de placement (1) et dudit au moins un deuxième partenaire de placement (2) ou d'un dispositif de maintien (3) destiné audit au moins un deuxième partenaire de placement (2),
b) un dispositif d'évaluation de position (50) crée un jeu de données de sortie (40) à partir d'un traitement des images précédemment obtenues (33, 35), dans lequel
c) le jeu de données de sortie (40) issu d'un traitement des images précédemment obtenues présente une superposition des images pour leur affichage sur un dispositif de sortie et visualise le résultat de placement attendu, à savoir comprenant une image constituée d'une pluralité d'images de caméra superposées sur la base de l'état du dispositif de placement à l'instant respectif de l'acquisition des images (35', 33' ),
d) un alignement relatif du premier partenaire de placement (1) et dudit au moins un deuxième partenaire de placement (2) l'un par rapport à l'autre dans au moins une direction spatiale et/ou une direction de rotation est effectué au moyen d'un dispositif d'ajustement,
e) des erreurs systématiques du dispositif de placement (100), telles que des écarts de linéarité dans les axes et les guides dus aux tolérances mécaniques et/ou à des effets de température, sont calculées à l'aide de moyens de correction (82),
f) la création et l'affichage du jeu de données de sortie (40) sont effectués en temps réel, de sorte qu'un opérateur du système est en mesure d'effectuer de manière interactive l'alignement des partenaires de placement (1, 2) à l'aide de la représentation visuelle du résultat de placement attendu, dans lequel le dispositif de placement (100) comprend des moyens servant à corriger manuellement la position et/ou la rotation des partenaires de placement (1, 2), par exemple par une opération de commande manuelle (joystick) dans le cas de dispositifs d'ajustement motorisés et/ou par un décalage et/ou une rotation manuels des axes du dispositif d'ajustement par l'opérateur du système, et
g) l'alignement et l'ajustement des partenaires de placement (1, 2) sont effectués par un moyen servant à régler les images visuelles des premier et deuxième partenaires de placement (1, 2) dans le jeu de données de sortie (40), dans lequel l'alignement est réalisé, par exemple, en déplaçant une image partielle dans la représentation de l'image superposée à l'aide de la souris de l'ordinateur, dans lequel le dispositif ne se déplace pas et l'algorithme fonctionne toujours avec les images acquises en entrée, et
dans lequel, pour l'ajustement automatique des partenaires de placement (1, 2), les derniers paramètres valables relatifs à la position des images visuelles du composant et du substrat sont convertis sous une forme appropriée en coordonnées de déplacement du dispositif de placement.
